# EUROPEAN PATENT APPLICATION

(11) **EP 4 606 804 A1**
(43) Date of publication of application: **27.08.2025**
(21) Application number: 24159182.5
(22) Date of filing: 22.02.2024
(51) Int. Cl.: C07F 5/02, C09K 11/06, H10K 85/00

(54) **METHOD FOR THE PREPARATION OF OXYGEN SUBSTITUTED CLOSO-CARBORATES**

(71) Applicant: beeOLED GmbH, 01217 Dresden (DE)
(72) Inventor: Kaden, Felix, 01127 Dresden (DE)
(74) Representative: Altmann Stößel Dick Patentanwälte PartG mbB

(57) **Abstract**

A process for the preparation of substituted carba-closo-dodecaborate derivative of general formula **(1-1),** comprises two major steps:
c) reacting a starting compound of a general formula **(1-2),** containing at least one OH or OD group, with an inorganic or organic base, in a solvent, to form an intermediate compound of a general formula **(1-3),** in which the OH and OD groups present in (1-2) are converted to OX groups,
d) followed by reacting a mono-valent, divalent or multi-valent derivatization reagent with general formulae **Y-R⁶, Y-R⁴-Y,** or **YₙR⁵,** respectively, in a solvent with the compound of general formula **(1-3)** to obtain the substituted 1-carba-closo-dodecaborate derivative with the general formula **(1-1),** in which the OX groups present in **(1-3)** are converted to OR² groups,
with at least or exactly one OH or OD group present in the starting compound of general formula (1-2) which undergoes alkylation, acylation or arylation reactions.

## Description

### Technical Field

This invention discloses a high yield and high selectivity process for producing 1-carba-closo-dodecaborate derivatives by alkylation, acylation or arylation of hydroxy-substituted 1-carba-*closo*-dodecaborates, some of the products obtained, coordination compounds and electroluminescent devices containing them.

### Background

Negatively charged boron hydride clusters, carba-closo-dodecaborate anions, as a class of the robust and weakly coordinating anions, have found many applications in such important fields as organic and superacid chemistry, in catalyses [Grime, Dalton Trans. 2015, 44, 5939], for nuclear fusion, and medicine [Hawthorne, Angew. Chem., Int. Ed. Engl. 1993, 32, 950; Soloway, Tjarks, et al. Chem. Rev. 1998, 98, 1515], for non-linear optics and liquid crystals [Collings: Liquid Crystals, 2nd Ed.: Princeton University Press: Princeton, NJ, 2001; Blanch, Sleeman, White et al. Nano Lett. 2002, 2, 147], for molecular devices and nanotechnology applications [Hawthorne, Zink et al. Science 2004, 303, 1849], as well as for energy storage applications [Zheng, F.; Kotobuki, M. et al. J. Power Sources 2018, 389, 198; Gao, Sun, et al. Adv. Mater. 2018, 30, 1705702; Wang, Richards, et al. Nat. Mater. 2015, 14, 1026]. Functionalization of the carba-closo-dodecaborate anions, [closo-CB₁₁H₁₂]⁻, such as, by halogenation [Kaleta, J.; Tarabek, et al. Inorg. Chem. 2012, 51, 10819] and methylation [Douvris, Michl. Chem. Rev. 2013, 113, PR179] was proven to be a powerful tool to further decrease nucleophilicity of the carba-closo-dodecaborate anion, for use in catalyses and studies of mechanism of chemical reactions.

For other applications, such as in medicine or for highly stable batteries, coupling of the carba-closo-dodecaborate anions with other building blocks, such as, bio-linkers and biomolecules, drugs, nanoparticles, polymers and surfaces, is highly desirable. For these purposes, connection via the CH-vertex is used predominantly if not exclusively. As the CH group in the carba-closo-dodecaborate has a somewhat acidic character, it can be selectively deprotonated and many nucleophilic groups can be straightforwardly introduced. For example, alkylation of the of the deprotonated carba-closo-dodecaborate anion by alkyl halides proceeds smoothly [King, Janousek, et al. J. Am. Chem. Soc. 1996, 118, 3313]. Also, a nucleophilic addition of the carba-*closo*-dodecaborate anion by the deprotonated 1C-vertex to electrophilic double bonds, such as to a porphyrine aldehyde, epoxides and carbon dioxide, has been reported [Kennedy, Collect. Czech. Chem. Commun. 2002, 67, 869; Jelinek, Plesek, Czech. Chem. Commun. 1986, 51, 819]. A 2-dimethylaminoethyl substituent can also be introduced by alkylation with 2-dimethylaminoethyl chloride [Eriksson, Vyakaranam, J. Org. Chem. 2007, 72, 2351]. However, functionalization at the CH, position 1, vertex has some serious drawbacks. Here, the negative charge of the anion resides mostly around the boron of the position 12. Therefore, functionalization at the CH, position 1, often leads to highly polar organic molecules that are difficult to solubilize. They often tend cluster. For many applications, well soluble isolated molecules are highly desirable, which cannot be achieved by substitution at the CH, position 1.

Formula (1-0) below shows the conventional vertex numbering in the carba-closo-dodecaborate.

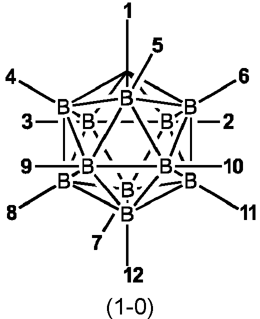

Regarding the derivatization possibilities beyond the CH-vertex (position 1), there are eleven BH-vertexes in the carba-*closo*-dodecaborate anion, having a hydridic character, which could also be amenable for attack by electrophilic reagents. The B-H bond in the position 12 is the most reactive toward electrophiles, however reactivities of the positions 7-11 are not far behind. The low difference in reactivities of the boronic vertexes poses serious difficulties in selective mono-derivatization of the carba-*closo*-dodecaborate anion [Douvris, Michl. Chem. Rev. 2013, 113, PR179].

A direct alkylation of boron vertexes is usually performed with alkyl triflates in the presence of a base, usually calcium hydride added to remove triflic acid. The most common type of alkylation is methylation, which introduces up to eleven methyl groups into carba-*closo-*dodecaborate anion, converting it into the undecamethylated anion. It is usually very difficult or impossible to avoid formation of complex mixtures of partially methylated derivatives. Therefore, this alkylation has no preparative importance for a selective introduction of just a single alkyl group. Furthermore, the polyalkylation variant is not applicable for introduction of of alkenyl-, alkynyl-, or aryl-substituents because of harsh conditions provided by the necessary presence of aggressive triflic acid [Clayton, King, et al. J. Inorg. Synth. 2010, 35, 56].

Halogenation reaction is also not selective. For example, chlorination of carba-closo-dodecaborate anion with elemental chorine or *N*-chlorosuccinimide produces a mixture of partially chlorinated anions, from which the mono-substituted 12-chloro-carba-*closo-*dodecaborate anion could be isolated with low yield, and (7,12-dichloro-), (7,8,9,10,12-pentachloro-) and (7-12-hexachloro) anions are also formed in the reaction [Xie, Tsang, et al. Inorg. Chem. 1997, 36, 2246].

The use of modern transition-metal-catalysed coupling reactions, such as Kumada coupling was attempted with 12-iodo-dodecaborane and other B-halogenated carba-*closo-*dodecaborates, however with a moderate to low success. [Plesek, Hermanek, et al. Collect. Czech. Chem. Commun. 1986, 51, 819; Finze, M. Inorg. Chem. 2008, 47, 11857].

Grüner et al. have reported attachment of a dioxane ring to the 12-position of the carba-closo-dodecaborate anion occurring under strong Lewis acid (dimethylsulphate) catalyst and leading to the formation of zwitterionic product {12-[O(CH₂CH₂)₂O]⁺-1-CB₁₁H₁₁⁻}⁰ , however the reported yield is low (22-28%). The obtained compound could be further derivatized in a quite efficient nucleophilic ring-opening reaction, however the low accessibility of the zwitterionic intermediate complicated by a high price of the starting carba-*closo*-dodecaborate diminishes the applicability of the whole derivatization approach [Grüner, Císaiřová, et al. *Collect. Czech. Chem. Commun.* **2002**, *67*, 953].

Therefore, no suitable synthesis procedures are known today, that yield functionalized carba-closo-dodecaborates anions with high selectivity in synthesis yield and high solubility as desired for most applications of those promising weakly coordinating anions.

In this context, the disclosure, of Grüner Císaiřová, et al. reports a simple method to oxidize the carba-*closo*-dodecaborate anion selectively at the 12-position to produce 12-(HO)-CB₁₁H₁₁⁻ near quantitatively by using sulfuric acid, a cheap oxidizing agent. In other work, oxidation with hydrogen peroxide leads to carba-closo-dodecaborate anion in which all eleven vertexes are substituted with hydroxyl groups [Peymann, Herzog,et al. Angew. Chem., Int. Ed. 1999, 38, 1061. Stasko, Perzynski, Wasil, Chem. Commun. 2004, 708]. To our surprise, little is done toward a further derivatization of 12-(HO)-CB₁₁H₁₁⁻ and other hydroxylated carba-*closo-*dodecaborates. We proposed that if the corresponding chemistry is developed, 12-(HO)-CB₁₁H₁₁⁻ and its perhydroxylated analog would become a useful and versatile synthon for producing a variety of 12-subsituted carba-*closo*-dodecaborates.

However, today no suitable methods are known to further derivatise the above mentioned 12-Hydroxy carba-*closo*-dodecaborate 12-(HO)-CB₁₁H₁₁⁻ anion with high yield and selectivity.

While from the first sight, the carborate anion seems to be a quite symmetric ball, the presence of the carbon atom strongly polarizes the carborate structure and concentrates the negative charge preferentially around the 12B vertex.

This polarization manifests itself, for example, in the crystalline structure of the carborate salts, in which the positively charged ions are preferentially located at the 12B vertex and not at the 1C vertex. It could be therefore proposed that carborates attached to another molecules or objects via the 12B vertex would have significantly different properties compared to the carborates attached via the 1C vertex.

Methods for attachment of carborates via the boron vertexes, especially via 12B vertex, are largely missing in the literature.

Previous patent applications of beeOLED GmbH show closoborane covalently linked to ring nitrogen via 1,2-ethylene or 1,3-propylene spacers:
WO 2021/244801 discloses metal-organic coordination compounds that can have carba-*closo-*dodecaborate anions as counter ions, see Fig. 2K and 5.Fig. 2B shows crown ethers without anions. WO 2022/218562 discloses metal-organic coordination compounds that can have covalently linked anions, see Fig. 1A to 7A. Fig. 2B shows crown ethers without anions. Coordination compounds having two covalently linked carba-*closo*-dodecaborate anions are shown in Fig. 5, see e.g. compounds 45-47, 88-90, 132-134, 178-180, 225 and 226.

Previous non-published patent applications of beeOLED GmbH show closoborane covalently linked to ring nitrogen via 1,2-ethylene or 1,3-propylene spacers:
European Patent application 22215963.4, filed on 22.12.2022, see Fig. 1, L11.51, L11.56, L12.37, L12.38, Fig. 4, E10.

European Patent application 23189891.7, filed on 04.08.2023, see Fig. 2, M64, M65, Fig. 4, E13.

European Patent application 2317475.3, filed on 22.05.2023, see Fig. 1, L17, Fig.5.

Part of the ring structure/inserted in ring:
European Patent application 23189892.5, filed on 04.08.2023, see Fig. 2, M37, M38, M41. None of the ligands in the older applications contains the carborane linked to the ring nitrogen by a N-C(=O)-CH2- or -O-CH2-CH2- spacer/linker, but it is always -CH2-CH2- or -CH2-CH2-CH2-.

Carborates are thus important (free or covalently linked) anions/counter ions for central metal ions like Eu(ll) in metal-organic coordination compounds. Hence, there is a need in the art in the method for selective derivatization of carborates via the 12B vertex. This objective is addressed in the present invention by development of a process for diverse yet high yield derivatization of carborates containing at least one hydroxyl group. Such hydroxylated carborates used as starting materials - containing either one hydroxyl group, or several hydroxyl groups and optionally, other substituents, are readily available from corresponding unsubstituted and substituted carborates [Grüner, Císaiřová, et al. *Collect. Czech. Chem. Commun.* **2002**, *67*, 953. Peymann, Herzog, et al. Angew. Chem., Int. Ed. 1999, 38, 1061. Stasko, Perzynski, Wasil, Chem. Commun. 2004, 708].

The present invention discloses a convenient method for diverse derivatization of hydroxy-carba-*closo*-dodecaborates by means of various electrophilic compounds. The disclosed process complements the process currently dominating in the art for the derivatization of carba-*closo*-dodecaborates almost exclusively involving the CH-vertex.

Besides that, we surprisingly found that the carba-*closo*-dodecaborates with an oxygen substituent at 12 position, in many cases, have a much better solubility and volatility, compared to the 1-C-substituted carba-*closo*-dodecaborates, prepared according to the prior art. Particularly, we found that a Eu(II)-complex comprising a diaza-18-crown-6 ether with two, via the 12B-O-vertex covalently attached carba-c/oso-dodecaborate anions as organic ligand, possesses a good solubility in moderately polar solvents (e.g., tetrahydrofuran), and a high volatility under high vacuum conditions which is necessary for sublimation, whereas its 1-C-substituted counterpart is insoluble and not volatile.

In another paper, Watanabe et al have reported that halogenation at the 12B-vertex drastically (more than 10 times) improves the solubility compared to both unsubstituted and corresponding 1C-vertex-substituted carba-*closo*-dodecaborates designed for use in magnesium ion batteries [Watanabe, Kanazawa, et al. Mater. Adv. 2021, 2, 937]. While an exact origin for the improved processability of the 12B-O-substituted carba-*closo-*dodecaborates is not known, we tentatively explain the effect in terms of different distribution of charges in carba-*closo*-dodecaborates. Particularly, it is known that positively charged counterions in crystalline salts of unsubstituted and 1C-vertex-substituted carba-*closo-*dodecaborates tend to coordinate next to the 12-B-vertex, as this effectively appears to be the most negatively charged point of the carba-*closo*-dodecaborate [Zharov, Weng, et al. J. Am. Chem. Soc. 2004, 126, 12033]. In this configuration, the attractive interactions between the ions are maximized, which accounts for the reduced solubility and volatility. However, if the 12B-vertex is blocked by substituents (even when they are relatively compact as CI or Br atoms), the positively charged counterion are located in the nearby 7-12 positions, where the negative charge of the carborate is negligible. This arrangement leads to a reduced attraction between the counterions, which increases the molecular character of the salts and improves solubility and volatility thereof.

Besides the mono-substitution of the carborates via the 12B vertex, the present invention provides the route for introduction of several substituents at once, when the starting carborate contains several hydroxy-groups.

Thus, the present invention discloses a method for versatile derivatization of carba-closo-dodecaborates with high synthesis yield. Thereby functionalized weakly coordinating anions with improved processability are obtained.

The objects are achieved according to the present invention by a process for the preparation of substituted carba-*closo*-dodecaborate derivative of general formula **(1-1)**, comprising two major steps:
a) reacting a starting compound of general formula **(1-2)**, containing at least one OH or OD group, with an inorganic or organic base, in a solvent, to form an intermediate compound of general formula **(1-3)**, in which the OH and OD groups present in (1-2) are converted to OX groups,
b) followed by reacting a mono-valent, divalent or multi-valent derivatization reagent with general formulae **Y-R⁶**, **Y-R⁴-Y**, or **YₙR⁵**, respectively, in a solvent with the compound of general formula **(1-3)** to obtain the substituted 1-carba-closo-dodecaborate derivative with the general formula **(1-1),** 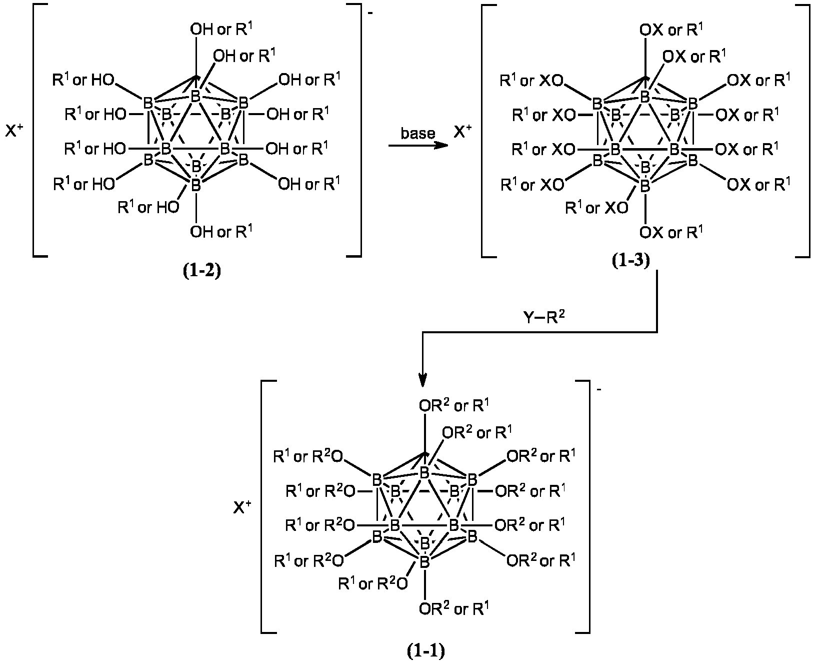 in which the OX groups present in **(1-3)** are converted to OR² groups,
   with at least or exactly one OH or OD group present in the starting compound of general formula **(1-2)** which undergoes alkylation, acylation or arylation reactions, and with the non-reacted OH groups and all groups R¹ remaining unreacted during the process steps a) and b), with
   - **R¹** being identical or different in each occurrence selected from hydrogen, deuterium, iodine, bromine, chlorine, fluorine, an alkyl, an alkoxy or an aryl group, preferably hydrogen or a methyl group, most preferably hydrogen;
   - **X+ or X** being a monocation identical or different in each occurrence selected from lithium, sodium, potassium, caesium, rubidium, silver, ammonium or alkyl ammonium, or half equivalents of a dication selected from: beryllium, magnesium, calcium, strontium or barium, preferably lithium, sodium or potassium, more preferably sodium;
   - **Y** being a monovalent leaving group selected from iodide, bromide, chloride, fluoride, tosylate, mesylate, triflate or other leaving groups,
   - **R²** being a monovalent organic group **R⁶**, a divalent organic group **R⁴** being covalently linked to a second carba-closo-dodecaborate derivative of general formula **(1-1)** or a polyvalent organic group **R⁵** being covalently linked to (n-1) further carba-closo-dodecaborate derivatives of general formula **(1-1);**
   - **R⁴** being a divalent organic group being identical or different in each occurrence and derived from an organic molecule containing at least two hydrogen atoms by removing two hydrogen atoms, preferably from an aliphatic or aromatic hydrocarbon than can contain cyclic or heterocyclic groups and substituents;
   - **R⁶** being a monovalent organic group being identical or different in each occurrence and derived from an organic molecule containing at least one hydrogen atom by removing a hydrogen atom, preferably alkyl, aryl, heteroaryl, or acyl;
   - **R⁵** being a polyvalent organic group being identical or different in each occurrence and derived from an organic molecule containing at least n hydrogen atoms by removing n hydrogen atoms, preferably from an organic polymer containing side groups from which the hydrogen atoms are removed; n being a number of at least 3, preferably at least 10, more preferably at least 50;
   wherein in formula **(1-2), R¹** can replace **OH,** in formula **(1-3) OX,** in formula **(1-1) OR²** in the respective positions of the carba-*closo*-dodecaborate structure.

The expression "with at least or exactly one OH or OD group present in the starting compound of general formula **(1-2)** which undergoes alkylation, acylation or arylation reactions, and with the non-reacted OH groups and all groups R¹ remaining unreacted during the process steps a) and b)," is intended to define that at least or exactly one OH or OD group is present in the starting compound of general formula **(1-2).** The single OH or OD group or at least one of the two or more OH or OD groups present in the starting compound undergoes an alkylation, acylation or arylation reaction in the process of the present invention. Thus, alkylation, acylation or arylation reactions of the OH and OD groups present in the starting compound of general formula (1-2) can be complete or only partial/incomplete, with at least one of these OH or OD groups being reacted, but not all of them. The degree or percentage of reaction of the initial OH and OD groups in the starting compound may be controlled by controlling the stoichiometry of the reaction and reagents.

Preferably, the starting compound of general formula **(1-2)** has only a single OH group preferably in the vertex 12 position, and all other 11 groups of R¹ are hydrogen, and with X⁺ present in the starting compound of general formula (1-2) being alkali (e.g.sodium) or tri-alkylammonium, preferably tri-alkylammonium, and with X and X⁺ present in the intermediate compound of general formula (1-3) being alkali (e.g. sodium or potassium) or tri-alkylammonium, preferably sodium. Then, formula **(1-2)** and **(1-3)** are preferably as follows (in the preferred embodiment of the present invention):

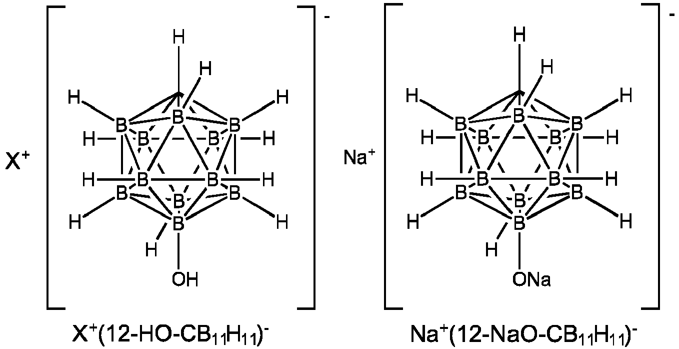

In the above process, preferably the solvent is an aprotic solvent, preferably selected from toluene, diethyl ether, dioxane, dimethylsulphoxide, acetonitrile, dimethylformamide (DMF), or their mixtures, more preferably from DMF and THF, most preferably from THF.

In the above process, preferably the derivatization agent **Y-R²** is selected from Cl-CH₂-CO-NH-R³, Br-CH₂-CO-NH-R³, I-CH₂-CO-NH-R³, Cl-CH₂-CO-O-R³, Br-CH₂-CO-O-R³, I-CH₂-COO-R³, Cl-CH₂-CO-R³, Br-CH₂-CO-R³, I-CH₂-CO-R³, Cl-CO-R³, Br-CO-R³, with R³ representing any covalently linked monovalent organic group formed by removing a hydrogen atom from an organic molecule containing at least one hydrogen atom.

In the above process, preferably the base is selected from alkali hydroxides, alkali alkoxides, alkali bis(trimethylsilyl)amides, alkali diisopropylamides, organolithium reagents, trialkylamines, or organic superbases, such as aminophosphines, phosphazenes, phosphanes, carbodiphosphoranes, amidines, guanidines, multicyclic polyamines, bispidines, or their mixtures, preferably from alkali hydrides, most preferably from sodium hydride.

In the above process, preferably the groups **R⁴**, **R⁵** and **R⁶** are covalently linked to Y or the substituted carba-*closo*-dodecaborate derivative of general formula **(1-1)** via a group (**R⁷**)₂N-C(=O)-(CH₂)ₘ--- or via a group (**R⁷**)₂N-(CH₂)ₘ--- with m being a number from 1 to 12, preferably from 1 to 4, e.g. 1, 2, 3 or 4, and wherein (**R⁷**)₂ is the remainder of the groups **R⁴**, **R⁵** and **R⁶** and --- is the linkage to the oxygen of the carba-*closo*-dodecaborate derivative and wherein the two groups the groups **R⁷** can be the same or different and can be covalently linked with each other. Preferably, **R⁴** is covalently linked to **Y** or the substituted carba-closo-dodecaborate derivative of general formula **(1-1):** via two groups N-C(=O)-(CH₂)ₘ--- or (**R⁷**)₂N-(CH₂)ₘ--- with m being a number from 1 to 12, preferably from 1 to 4, e.g. 1, 2, 3 or 4, and the two nitrogen atoms thereof are covalently linked with each other via two hydrocarbon chains which can be interrupted by one or more non-adjacent heteroatoms, independently selected from NR⁸, O, S, BR⁸ with R⁸ being hydrogen or a monovalent organic group derived from an organic molecule containing at least one hydrogen atom by removing a hydrogen atom, preferably alkyl, aryl, heteroaryl, or acyl, so that a heterocyclic group is formed. More preferably, the heterocyclic group contains 12 to 48, preferably 15 to 24, more preferably 18 to 20 ring-forming atoms of which 2 to 4 atoms are nitrogen atoms, of which 2 to 4 atoms are oxygen and/or sulphur atoms, with the proviso that in total 4 to 6 heteroatoms are present in the ring-forming atoms, and the heteroatoms are non-adjacent.

The organic group **R²** can be selected from all organic groups that do not interfere with the reaction in an adverse manner, e.g. hinder the reaction or take part in the reaction. Preferably, it is selected from s1 to s42, with the dashed line indicating the linkage to Y or the oxygen of the substituted carba-closo-dodecaborate derivative of general formula (1-1) 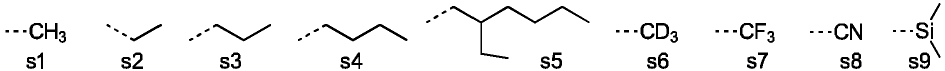 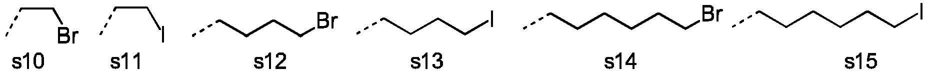 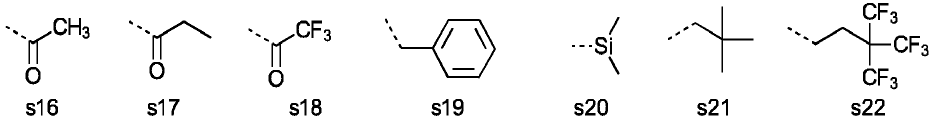 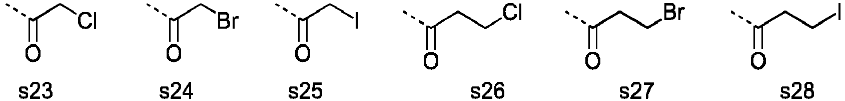 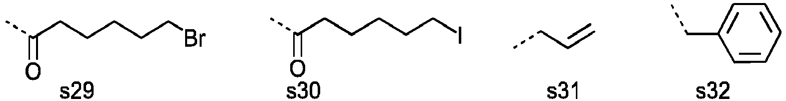 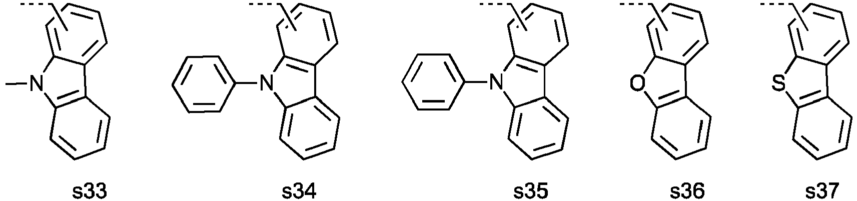 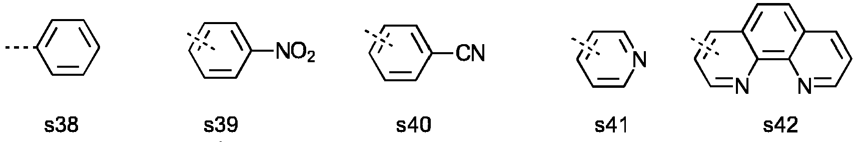 and organic group **R⁴** is selected from m1 to m5, with the dashed line indicating the linkage to Y or the oxygen of the substituted carba-closo-dodecaborate derivative of general formula (1-1) 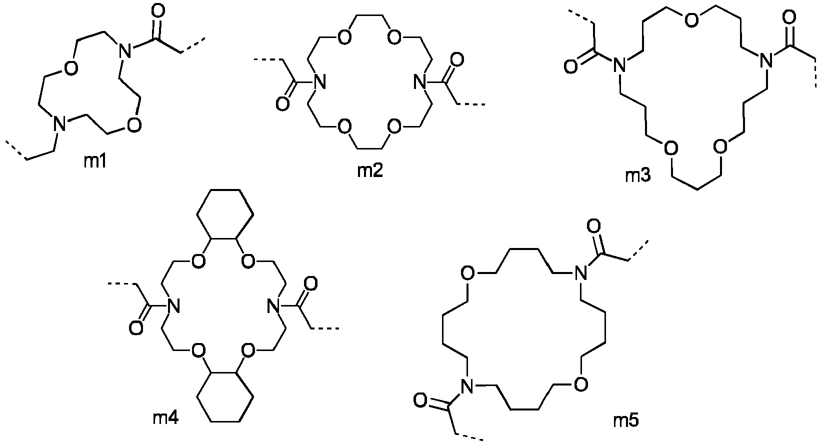 and **YₙR⁵** is a multivalent organic compound having a molecular weight of more than 1500 g/mol, and wherein the number **n** of leaving groups **Y** is greater than two, preferably greater than ten, most preferably, greater than fifty, such that a multitude of substituted carba-*closo-*dodecaborates according to formula **(1-1)** is covalently attached to a linear or branched polymer backbone. Preferably, the multivalent organic group R⁵ is selected from p1 to p4, with n being greater than two, preferably greater than ten, most preferably greater than fifty, with k being a number from 1 to 4, and the dashed line indicating the linkage to the oxygen of the substituted carba-*closo*-dodecaborate derivative of general formula **(1-1)**

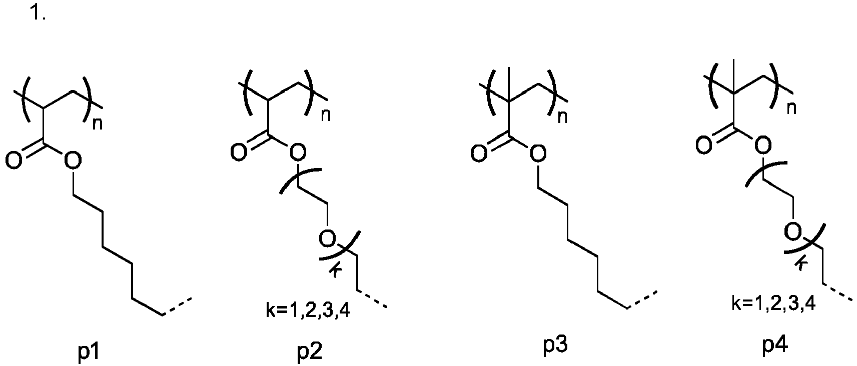

The objects are furthermore achieved by a substituted carba-closo-dodecaborate derivative of above general formula **(1-1),** wherein the groups **R⁴**, **R⁵** and **R⁶** are covalently linked to the substituted carba-closo-dodecaborate derivative of general formula **(1-1)** via a group (**R⁷**)₂N-C(=O)-(CH₂)ₘ--- or via a group (**R⁷**)₂N-(CH₂)ₘ--- with m being a number from1 to 12, preferably from 1 to 4, e.g. 1, 2, 3 or 4, and, (**R⁷**)₂ is the remainder of the groups **R⁴**, **R⁵** and **R⁶** and --- is the linkage to the oxygen of the carba-*closo*-dodecaborate derivative, and wherein the two groups **R⁷** can be the same or different and can be covalently linked with each other. Preferably, **R⁴** is covalently linked to the substituted carba-closo-dodecaborate derivative of general formula **(1-1):** via two groups N-C(=O)-(CH₂)ₘ--- or (**R⁷**)₂N-(CH₂)ₘ--- with m being a number from 1 to 12, preferably from 1 to 4, e.g. 1, 2, 3 or 4, and the two nitrogen atoms thereof are covalently linked with each other via two hydrocarbon chains which can be interrupted by one or more non-adjacent heteroatoms, independently selected from NR⁸, O, S, BR⁸ with R⁸ being hydrogen or a monovalent organic group derived from an organic molecule containing at least one hydrogen atom by removing a hydrogen atom, preferably alkyl, aryl, heteroaryl, or acyl, so that a heterocyclic group is formed. Preferably, the heterocyclic group contains 12 to 48, preferably 15 to 24, more preferably 18 to 20 ring-forming atoms of which 2 to 4 atoms are nitrogen atoms, of which 2 to 4 atoms are oxygen and/or sulphur atoms, with the proviso that in total 4 to 6 heteroatoms are present in the ring-forming atoms, and the heteroatoms are non-adjacent. Organic group R⁴ can also be selected from m1 to m5, or as defined above. **R⁵** can be a multivalent organic compound having a molecular weight of more than 1500 g/mol, and wherein the number **n** is greater than two, preferably greater than ten, most preferably, greater than fifty, such that a multitude of substituted carba-*closo*-dodecaborates according to formula (1-1) is covalently attached to a linear or branched polymer backbone. Preferably, the multivalent organic group R⁵ is selected from p1 to p4, with n being greater than two, preferably greater than ten, most preferably greater than fifty, with k being a number from 1 to 4, and the dashed line indicating the linkage to the oxygen of the substituted carba-*closo*-dodecaborate derivative of general formula **(1-1).**

The objects are furthermore achieved by the use of substituted carba-*closo*-dodecaborate derivatives of general formula **(1-1)** as defined in the previous paragraph for preparing metal-organic coordination compounds comprising a divalent Europium coordinated by the substituted carba-*closo*-dodecaborate derivatives of general formula **(1-1).**

The objects are furthermore achieved by a charge-neutral metal-organic coordination compound comprising a divalent Europium coordinated by a macrocyclic organic ligand, wherein the macrocyclic organic ligand contains 12 to 48, preferably 15 to 24, more preferably 18 to 20 ring-forming atoms of which 2 to 4 atoms are nitrogen atoms, of which 2 to 4 atoms are oxygen and/or sulphur atoms, with the proviso that in total 4 to 6 heteroatoms are present in the ring-forming atoms, and the heteroatoms are non-adjacent, and the macrocyclic organic ligand is twofold negatively charged by two substituted carba-*closo*-dodecaborate derivatives of general formula **(1-1)** covalently linked therewith via two groups N-C(=O)-(CH₂)ₘ--- or (**R⁷**)₂N-CH₂)ₘ-- with m being a number from 1 to 12, preferably from 1 to 4, e.g. 1, 2, 3 or 4, and with the two nitrogen atoms thereof being covalently linked with each other via two hydrocarbon chains which can be interrupted by one or more non-adjacent heteroatoms, independently selected from NR⁸, O, S, BR⁸ with R⁸ being hydrogen or a monovalent organic group derived from an organic molecule containing at least one hydrogen atom by removing a hydrogen atom, preferably alkyl, aryl, heteroaryl, or acyl, so that the macrocyclic ring of the macrocyclic organic ligand is formed.

The objects are furthermore achieved by a charge-neutral metal-organic coordination compound comprising a divalent Europium coordinated by a macrocyclic organic ligand, wherein the macrocyclic organic ligand having a cyclic or polycyclic organic group containing at least one ring structure having one or more, preferably two -NH- groups in the ring, wherein the H of the one or more, preferably two -NH- groups is replaced by a -(CH₂)ₘ-O-carba-*closo*-dodecaborate group or N-C(=O)-(CH₂)ₘ-O- carba-*closo*-dodecaborate group, with m being a number from 1 to 12, preferably from 1 to 4, e.g. 1, 2, 3 or 4, and the carba-c*loso-*dodecaborate group preferably being of formula **(1-1).**

A metal-organic coordination compound having a specific ring structure according to the present invention is described in the following, wherein the coordination compound comprises one lanthanide ion coordinated by a polycyclic organic ligand having the formula **2-1** 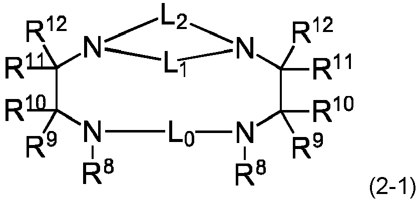 with
- **L₀**, **L₁**, **L₂** being independently each a divalent organic group formed by removing two hydrogen atoms from a substituted or non-substituted alkane, arylalkane, heteroarylalkane, arene, heteroarene, alkylarene, alkylheteroarene, dialkylarene or dialkylheteroarene, wherein alkane or alkyl can be interrupted by one or more oxygen or boron atoms, and with
- the sum of the number of atoms in the shortest sequences of atoms in **L₁**, and **L₂** between the two linkages of -L₁- and -L₂- and the remainder of the polycyclic ligand being less than 16 atoms, and
- **R⁹** to **R¹²** independently in each occurrence representing hydrogen, deuterium, halogen, or an organyl group, and
- **R⁸** representing substituted carba-*closo*-dodecaborate derivatives of general formula **(1-1)** covalently linked via a group N-C(=O)-(CH₂)ₘ--- or via a group - (CH₂)ₘ, with m being a number from 1 to 12, preferably from 1 to 4, e.g. 1, 2, 3 or 4, and wherein --- denotes the linkage to the oxygen of the carba-*closo-*dodecaborate.

Preferably, in the ligand **R₉** to **R₁₂** are hydrogen atoms, resulting in the structure according to formula 2-2 wherein R₁ has the meaning of above R₈.

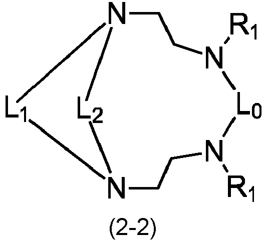

Preferably, **L₀** is a substituted or non-substituted 2 to 9 membered linear aliphatic hydrocarbon chain in which one aliphatic chain member can be replaced by a hetero atom selected from N, B, P, O, S, preferably from N and O, more preferably the hetero atom being O.

Preferably, **L₁**, and **L₂** are comprised of ethylene fragments or ethylene and ethyleneoxy fragments and the ligand has one of formulae **2-3-1** to **2-3-4** 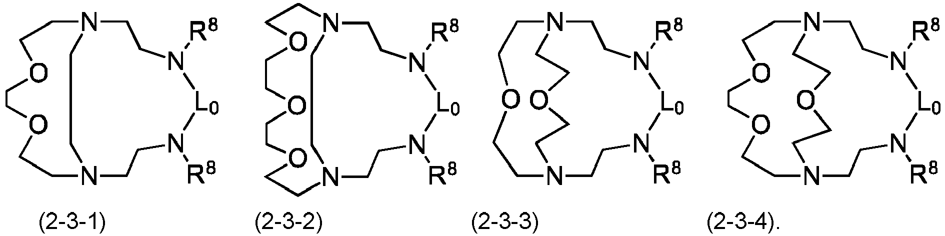 At least two atoms present in the shortest sequence of atoms of either **L₀**, **L₁**, or **L₂** can be part of a benzene, pyridine, pyrrole, pyrazole, furan, carbazole, dibenzofurane or benzofuran ring structure. Preferably, the one lanthanide ion is selected from Eu(II), Ce(III), and Yb(II), preferably from Eu(II), and Ce(III), more preferably the lanthanide being Eu(II). Preferably, the coordination compound comprises at least one negatively charged anion that is not covalently linked to the polycyclic organic ligand. The coordination compound can also have a structure according to formula (2-4) 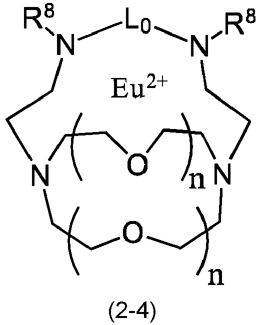 wherein
- **n** independently in each occurrence is 0, 1, 2, or 3, preferably 1 or 2, whilst the sum of both **n** is either 2 or 3 and
- **R⁸** representing substituted carba-*closo*-dodecaborate derivatives of general formula **(1-1)** covalently linked via a group N-C(=O)-(CH₂)ₘ--- or via a group - (CH₂)ₘ, with m being a number from 1 to 12, preferably from 1 to 4, e.g. 1, 2, 3 or 4, and wherein --- denotes the linkage to the oxygen of the carba-*closo-*dodecaborate
- **L₀** is a substituted or non-substituted 2 to 9 membered linear aliphatic hydrocarbon chain in which one aliphatic chain member can be replaced by a hetero atom selected from N, B, P, O, S, preferably from N and O, more preferably the hetero atom being O.

• Preferably, the shortest sequence of atoms forming the macrocycle in the macrocyclic organic ligand is made of 12 to 48, more preferably 15 to 24, most preferably 18 to 20 covalently linked atoms, wherein preferably the macrocycle contains 2 to 14, more preferably 3 to 10, most preferably 5 to 8 non-neighboring heteroatoms.

The coordination compound can also have a structure in which the macrocyclic organic ligand has the formula (3-1): 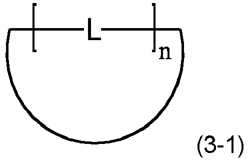 with
- **n** being 4-8, preferably 4-6, most preferably 6; and
- **L** being independently in each occurrence a divalent organic group formed by removing two hydrogen atoms from an organic molecule containing at least two hydrogen atoms, with
   ∘ the shortest sequence of atoms linking each L with the remainder of the macrocycle in the macrocyclic ligand being 2 to 4, preferably 3 atoms, and with
   ∘ one of those 2 to 4, preferably 3 atoms independently for each L being selected from the heteroatoms B, N, P, S, Se, Si or O, preferably N, S, or O, the other atoms of those atoms being carbon,
wherein the heteroatoms in the macrocycle are non-neighboring and the macrocycle contains at least two groups N-**R⁸** representing substituted carba-closo-dodecaborate derivatives of general formula **(1-1)** covalently linked via a group N-C(=O)-(CH₂)ₘ--- or via a group -(CH₂)ₘ, with m being a number from 1 to 12, preferably from 1 to 4, e.g. 1, 2, 3 or 4, and wherein --- denotes the linkage to the oxygen of the carba-*closo*-dodecaborate, wherein --- denotes the linkage to the oxygen of the carba-*closo*-dodecaborate.

Preferably, any further ring structures, forming part of the macrocyclic organic ligand in addition to the macrocycle are covalently linked with one macrocycle atom, or form part of the macrocycle by 1,2-, 1,3- or 1,4-linkage of the further ring structure, with the remainder of the macrocycle, and are not additionally covalently linked with other atoms of the macrocycle.

In the metal organic coordination compound the macrocyclic organic ligand can be selected from G1-G3 with one or two groups R⁸ having the same meaning as **R⁸** above in formula (3-1): 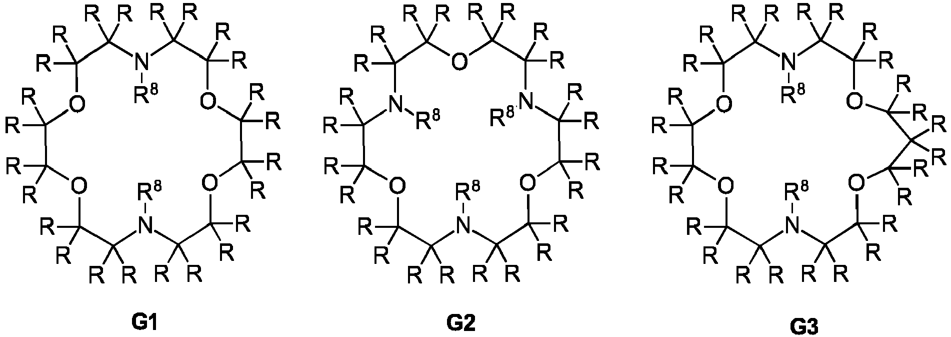 with
- **R** being identical or different in each occurrence and being H, D, or any covalently linked monovalent organic group formed by removing a hydrogen atom from an organic molecule containing at least one hydrogen atom whereby two, three, or four instances of R being present on the same or neighboring carbon atoms can be fused, and.

The metal organic coordination compound the ligand can be selected from E1 to E5:

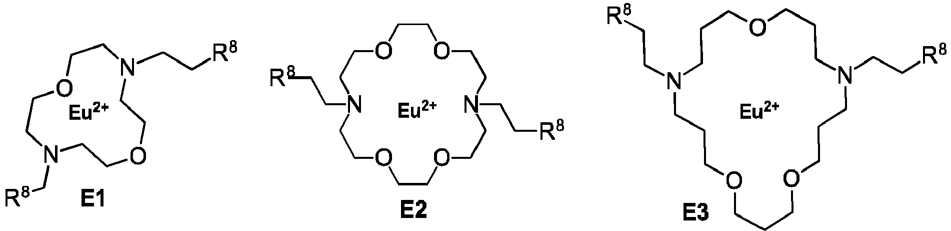

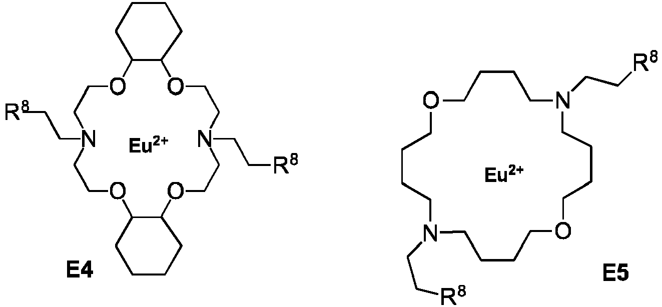

The charge-neutral metal-organic coordination compounds can be prepared by reacting the macrocyclic organic ligand with an Europium(II) compound, as for example disclosed in the two WO publications mentioned above.

The charge-neutral metal-organic coordination compounds can be used as an emitter material in organic electroluminescent devices, for example OLEDs, as for example disclosed in the two WO publications mentioned above.

The objects are furthermore achieved by an organic electroluminescent device comprising:
a first electrode,
a second electrode,
and an organic layer disposed between the first electrode and the second electrode, the organic layer comprising at least one charge-neutral metal-organic coordination compound as described above. The device layout can be as for example disclosed in the two WO publications mentioned above.

### Detailed Description

The invention relates to a process as defined in claim 1, e.g. to a process for the preparation of substituted carba-*closo*-dodecaborate derivative of general formula **(1-1),** comprising two major steps a) and b) as above.

Various embodiments relate to carba-closo-dodecaborates anion derivatives.

This invention discloses various preferred aspects of the process steps a) and b) for the preparation of substituted carba-closo-dodecaborate derivatives with the general formula **(1-1),** which can be combined with the above process and as defined in claim 1 as single features or a combination thereof:
a) reacting a starting compound with a general formula **(1-2),** containing at least one OH or OD group, with an inorganic or organic base, such as, alkali hydroxides, alkali alkoxides, alkali bis(trimethylsilyl)amides, alkali diisopropylamides, organolithium reagents, trialkylamines, or organic "superbases", such as, aminophosphines, phosphazenes, phosphanes, carbodiphosphoranes, amidines, guanidines, multicyclic polyamines, bispidines, or their mixtures, more preferred alkali hydrides, most preferred sodium hydride, in an aprotic solvent, such as toluene, diethyl ether, dioxane, dimethylsulphoxide, acetonitrile, dimethylformamide (DMF), or their mixtures, more preferred in DMF and THF, most preferred in THF, at temperatures ranging between -200 °C and +200 °C, more preferred between -78°C and 35°C, most preferred at room temperature, for a time ranging between 1 minute and 24 h, preferably between 0.5h and 3h, to form an intermediate compound or alkoxide with the general formula **(1-3),**
b) followed by reacting a mono-valent, divalent or multi-valent derivatization reagent with general formulae **Y-R⁶**, **Y-R⁴-Y**, or **YₙR⁵**, respectively, in an aprotic solvent as described for a); at concentrations of the intermediate (1-3) as described in a) for compound (1-2), at temperatures ranging between about -100 °C and +150 °C, more preferred between -78°C and 35°C, most preferred at room temperature, for a time ranging between 1 minute and 24 h, with both reactions a) and b) performed by utilizing concentrations of compound (1-2) and (1-3) between 2M and 0.001M, preferred between 1M and 0.01M, most preferred at 0.15M, and with quantities of compounds (1-2) and (1-3) between 1g and 100 kg, more preferred, between 100g and 1 kg, for both reactions a) and b) performed at the pressure range between 1 to 20 Bar, preferred at 1 Bar, in a reaction vessel made of glass, stainless steel or any other material inert to used reagents and solvents, to obtain the substituted 1-carbadodecaborate derivative with the general formula **(1-1),** 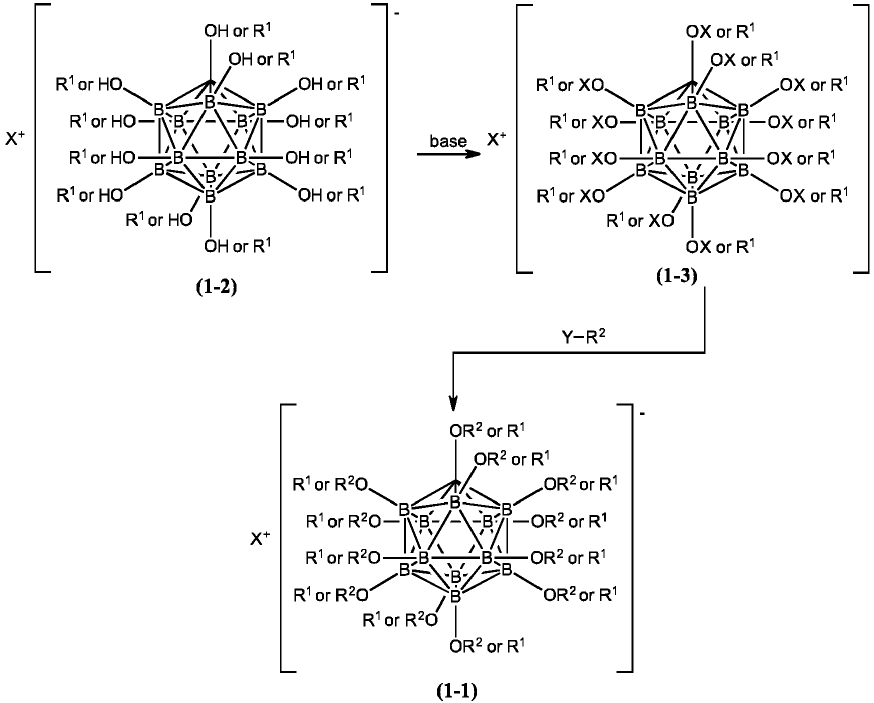 with at least or exactly one OH or OD group present in the starting compound, according to formula (1-2) undergo alkylation, acylation or arylation reactions according to the invention, and with the non-reacted OH groups and all groups R¹, remaining unreacted during the process, wherein
   - **R¹** being identical or different in each occurrence selected from hydrogen, deuterium, iodine, bromine, chlorine, fluorine, an alkyl, an alkoxy or an aryl group, more preferred a hydrogen or methyl group, most preferred hydrogen;
   - **X** being a singlx charged cation identical or different in each occurrence selected from lithium, sodium, potassium, caesium, rubidium, silver, ammonium or alkyl ammonium, or half equivalents of a dually charged cation selected from: beryllium, magnesium, calcium, strontium or barium, more preferred lithium, sodium or potassium, most preferred sodium;
   - **Y** being selected from iodide, bromide, chloride, fluoride, tosylate, mesylate, triflate or other leaving groups;
   - **R²** being a monovalent organic group being identical or different in each occurrence selected from formed by removing a hydrogen atom from an organic molecule containing at least one hydrogen atom, such as but not limited to alkyl, aryl, heteroaryl, or acyl.

In various preferred embodiments, the choice of the base used for deprotonation of starting compound (1-2) includes organic strong bases (so-called "superbases" that preferably have a higher basicity than NaOH, e.g. proton sponge (pKa = 12.1), which preferably are charge neutral and N-containing species), such as, but not limited to amidines, guanidines, phosphazenes, 1,4-diazabicyclo[2.2.2]octane, 1,8-dazabicyclo [5.4.0]undec-7-ene (DBU), 1,5-Di-azabicyclo[4.3.0]non-5-ene (DBN), aminophosphines (so-called Verkade base), 1,8-bis(dimethylamino)naphthalene, or other "proton sponges".

The starting carba-*closo*-dodecaborate (1-2) may preferably be presented by the carba-closo-dodecaborates (1-4) and (1-5), which contain one OH or OD groups located in the vertex 12 position with all other 11 groups of R¹ are identical to hydrogen. The numeration of vertexes is given in (1-0).

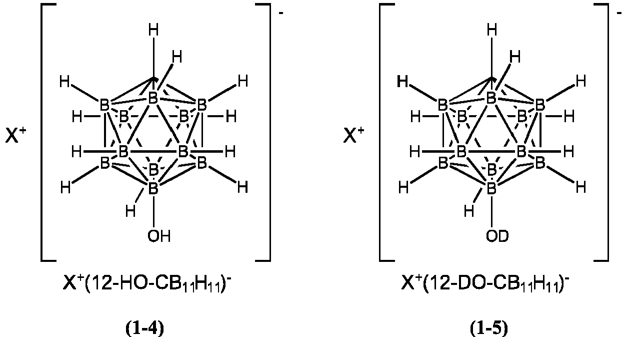

In this case, X and X⁺ present in the intermediate compound according to formula (1-3) being preferably in both instances sodium to give the intermediate structure (1-6):

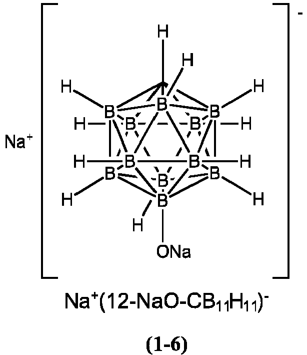

In further preferred embodiments, the starting carba-*closo*-dodecaborate (1-2) contains twelve OH or OD groups located at all vertexes of carba-*closo*-dodecaborate (1-2) and one of such compounds having 12 OH groups exemplified by (1-7).

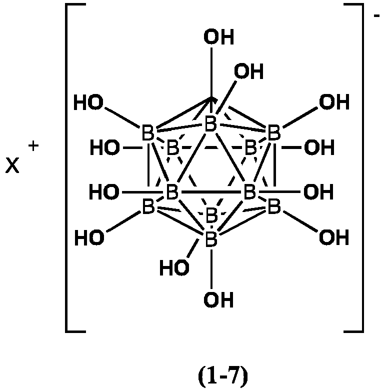

In other preferred embodiments, the starting compound (1-2) contains eleven hydroxyl groups incorporated at boron vertexes with R¹ at the carbon vertex being identical to hydrogen and one of such compounds having 11 OH groups exemplified by (1-8).

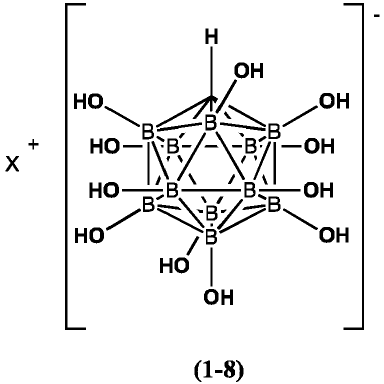

In other preferred embodiments, the starting compound (1-2) contains five OH or OD groups with R¹ at the carbon vertex being identical to hydrogen, and other six R¹ being bromide groups, and one of such compounds having 5 OH groups exemplified by (1-9).

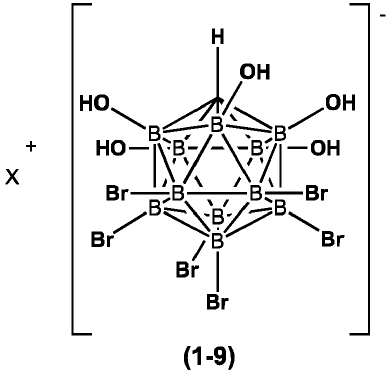

In further preferred embodiments, the groups R1 present in the starting compound with the general formula (1-2) remain unreacted during the process according to the invention.

In other preferred embodiments, the starting compound with the general formula (1-2) having more than one OH or OD group, such as but not limited to compounds (1-7)-(1-9), undergo complete alkylation, acylation or arylation reactions according to the invention, so that no unreacted OH or OD groups are present in the substituted carba-closo-dodecaborate derivatives with the general formula (1-1).

In other preferred embodiments, the starting compound with the general formula (1-2) having more than one OH or OD group, such as but not limited to compounds (1-7)-(1-9), undergo incomplete alkylation, acylation or arylation reactions according to the invention, so that some portion of unreacted OH or OD groups are present in the substituted carba-closo-dodecaborate derivatives with the general formula (1-1). The unreacted portion can preferably be 10 to 90%, more preferably 30 to 60% of the reactive groups.

In various embodiments of the invention, the starting compound (1-2) according to formula (1-2) contains X⁺ or X being preferably tri-alkylammonium, more preferably C1-6-trialkylammonium, most preferably C1-3-alkylammonium, e.g. trimethylammonium..
Further preferred embodiments of the invention disclose alkylation, acylation or arylation of the intermediate with the general formula (1-3) by reacting them with derivatization reagents **Y-R⁶**, **Y-R⁴-Y**, or **YₙR⁵** having one, two or multiple leaving groups Y.

In various preferred embodiments, the invention discloses the use of alkylation agents **Y-R⁶**, **Y-R⁴-Y**, or **YₙR⁵** with **Y** being bromide, more preferentially iodide most preferentially tosyl leaving groups.The term "leaving group" describes chemical groups Y that are cleaved from the molecule under reaction conditions, allowing the R groups to react with compound (1-3), specifically the -OX groups thereof.

In various preferred embodiments, the derivatization reagent **Y-R⁶** is selected from groups: Cl-CH₂-CO-NH-R³, Br-CH₂-CO-NH-R³, I-CH₂-CO-NH-R³, Cl-CH₂-CO-O-R³, Br-CH₂-CO-O-R³, I-CH₂-CO-O-R³, Cl-CH₂-CO-R³, Br-CH₂-CO-R³, I-CH₂-CO-R³, Cl-CO-R³, with R³ representing any covalently linked monovalent organic group formed by removing a hydrogen atom from an organic molecule containing at least one hydrogen atom. The process according to the invention utilizing these alkylation agents **Y-R⁶** benefit from the carbonyl groups present in the alpha-position with respect to the leaving group, which facilitates the alkylation reaction. Also preferred is the use of acylation agents in which **R⁶** is -CO-R³ with R³ representing any covalently linked monovalent organic group formed by removing a hydrogen atom from an organic molecule containing at least one hydrogen atom.

In other preferred embodiments, the derivatization reagent **Y-R⁶** is contains R6 allyl, propargyl, benzyl groups or groups with the general formula -CH₂-Ar, wherein Ar is any aryl or heteroaryl group, e.g. phenyl.

In other preferred embodiments, the invention discloses the use of arylation agents **Y-R⁶** with Y being chloride, bromide, or iodide, more preferred fluoride; and R⁶ being any substituted or non-substituted aryl or heteroaryl group. **Y-R⁴-Y**, and **YₙR⁵**.can be similar in structure to **Y-R⁶** with a plurality of leaving groups Y attached thereto instead of one. Further examples are listed below.

Some preferred cases of substituted carba-closo-dodecaborate derivatives (1-1), prepared according to the invention are exemplified in the compounds (1-10 to 1-13):

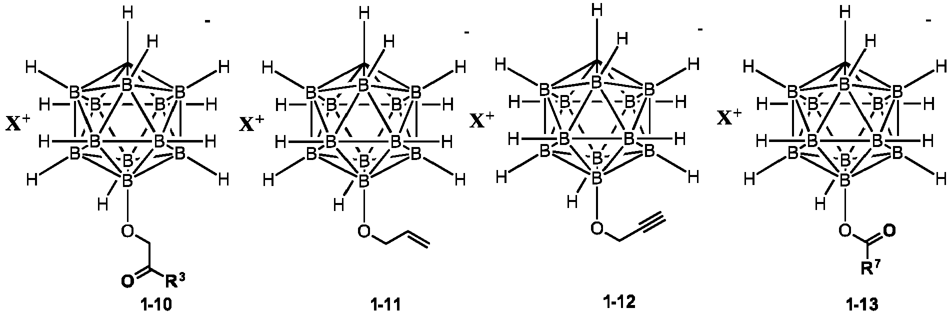

With R7 being an organic residue, for example hydrocarbon or heterohydrocarbon residue. Preferred are alkyl, aryl, heteroaryl.

Without limiting the general scope of the invention, further preferred examples of substituted carba-closo-dodecaborate according to formula (1-1), which can be prepared according to the invention, contain R⁶ selected from s1 to s42, with the dashed line indicating the linkage to the oxygen:

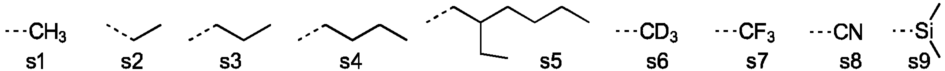

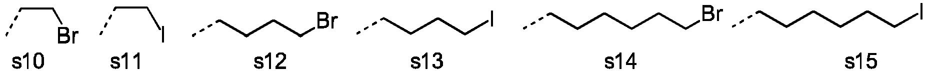

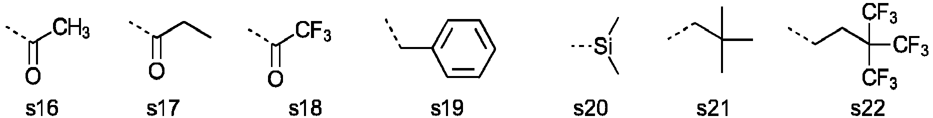

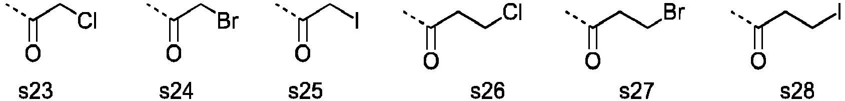

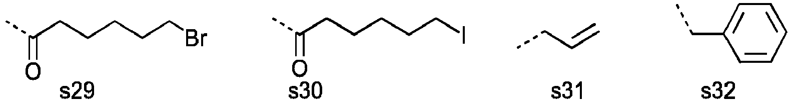

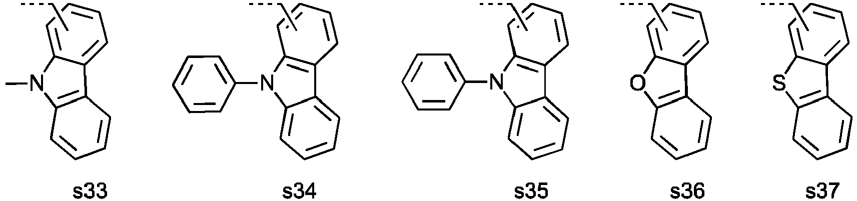

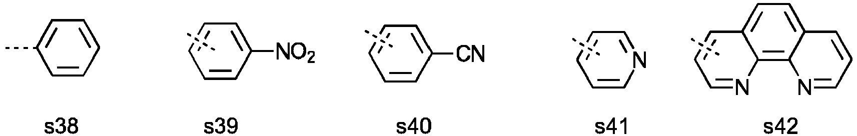

In various preferred embodiments, the derivatization reagent is the bivalent group **Y-R⁴-Y with R⁴** selected from m1 to m5, with the dashed line indicating the linkage to the oxygen:

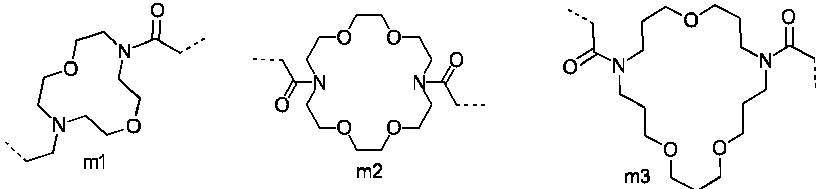

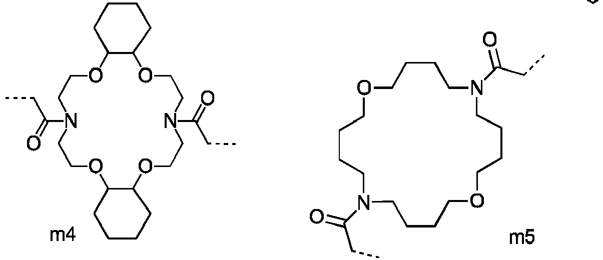

The use of the divalent derivatization agents **Y-R⁴-Y** is beneficial because they allow attachment of two 1-carbadodecaborate anions, as exemplified below for the preparation of derivatized crown ethers, e.g. crown (1-14).

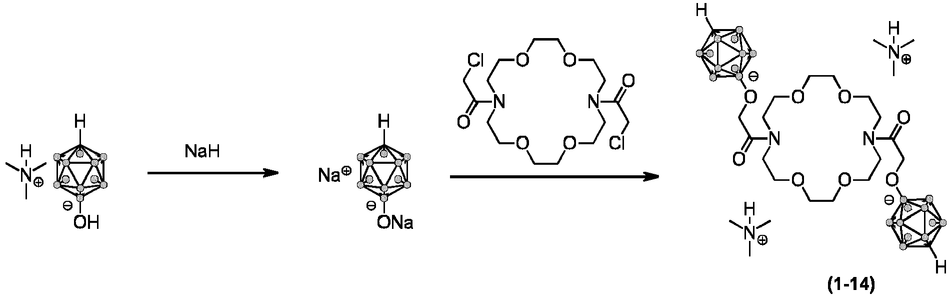

In other preferred embodiments the derivatization reagent YₙR⁵ is a multivalent organic compound having a molecular weight of more than 1500 g/mol, and/or wherein the number **n** of leaving groups **Y** is greater than two, preferably greater than ten, most preferably, greater than fifty, such that a multitude of substituted carba-closo-dodecaborate according to formula (1-1) is covalently attached to a linear or branched polymer backbone.

In even further preferred embodiments, the multivalent group R⁵ in the the derivatization reagent YₙR⁵ is selected from p1 to p4, with n being greater than two, preferably greater than ten, most preferably, greater than fifty, with k being varied from 1 to 4, and the dashed line indicating the linkage to the oxygen:

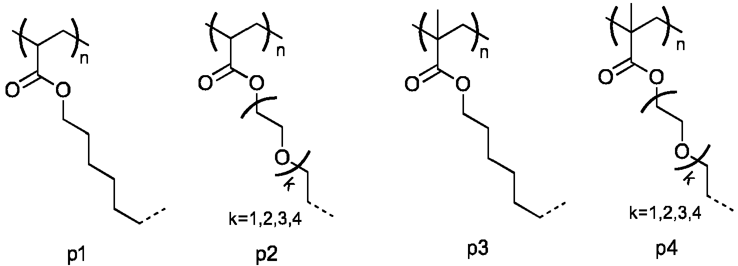

The scope of the invention extends to or encompasses the synthesis of oligomeric or polymeric compounds, such as but not limited to compounds (1-15) and (1-16). In further preferred embodiments, repeat units in the polymers or oligomers containing carba-closo-dodecaborate -based side groups can optionally be separated with other repeat units, which do not contain closo-dodecaborate -based side groups, such as in the compound (1-16). 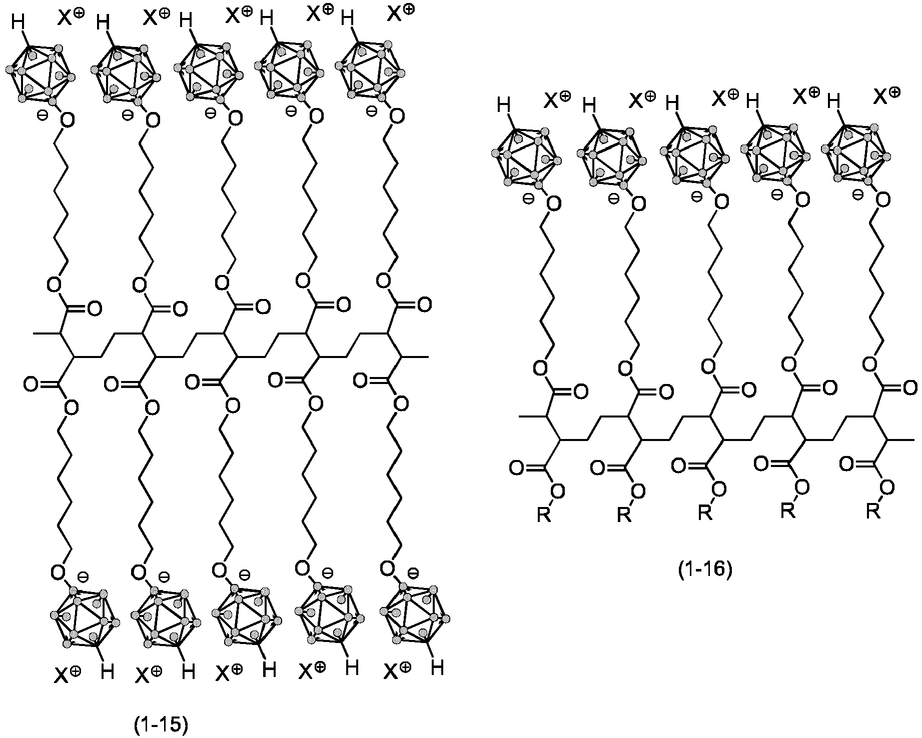 R being an organic group, preferably a (hetero)hydrocarbon group, preferably an alkyl or aryl or heteroaryl group.

In further preferred embodiments, carba-*closo*-dodecaborate derivatives obtained according to the invention contain two, three or several OR⁶ groups, as illustrated by compounds (1-17) and (1-18).

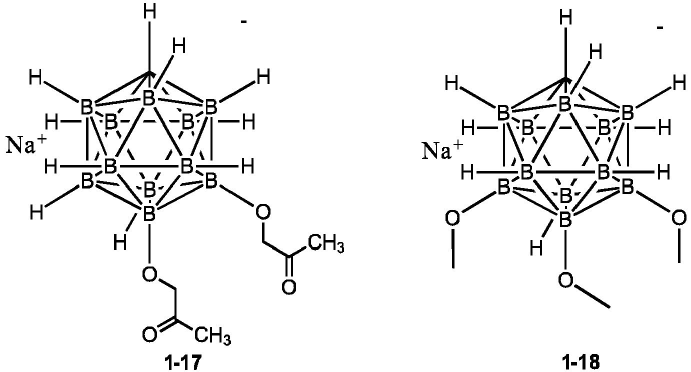

### Brief Description of the chemical formulae

In the chemical formulae, like reference characters generally refer to the same parts throughout the different views. The chemical structures, formulae or drawings are not necessarily to scale, emphasis is instead generally being placed upon illustrating the principles of the invention. In the following description, various aspects of the invention are described with reference to the chemical structures, formulae or drawings.

The above detailed description refers to the accompanying drawings that show, by way of illustration, specific details and aspects in which the invention may be practiced. The word "exemplary" is used herein to mean "serving as an example, instance, or illustration". Any aspect or design described herein as "exemplary" is not necessarily to be construed as preferred or advantageous over other aspects or designs. Various embodiments relate to carba-*closo*-dodecaborates anion derivatives.

Terms used in the present invention generally have meanings commonly understood by those of ordinary skill in the art, unless otherwise specified. The present invention is described in further detail below with reference to specific examples and with reference to the data. It will be understood that these examples are intended to illustrate the invention and are not intended to limit the scope of the invention in any way.

In this description, a coordination compound is taken to mean a compound where the central active metal, divalent Europium, is coordinated without a direct metal carbon bond. The terms complex, metal-organic compound, and coordination compound will be used interchangeably.

The term "macrocyclic" ring, molecule, or ligand refers to organic molecules comprising at least 9 atoms independently in each occurrence selected from O, S, Si, C, B, N, P as part of one cyclic chain of atoms with at least two of the bonds between the ring forming atoms being aliphatic. A crown ether, comprising of at least 3 -C-C-O- fragments is an example of a macrocyclic molecule. The term "macrocyclic" ring, molecule, or ligand refers to a single ring that is macrocyclic. Therfore, for example bicyclic or polycyclic groups are not considered as macrocyclic.

The "aza" designation in the fragments described herein, i.e., aza-crown ether, etc. means that one or more carbon atom or (other) heteroatom of a parent compound is replaced by a nitrogen atom, without any limitation. For example, in a crown ether, -O- is replaced by -NH- to give the respective aza crown ether. One of ordinary skill in the art can readily envision other nitrogen analogs of the aza-derivatives, and all such analogs are intended to be encompassed by the terms as set forth herein.

As used herein, "deuterium" refers to an isotope of hydrogen. Deuterated compounds can be readily prepared using methods known in the art.

It is to be understood that when a molecular fragment is described as being a substituent or otherwise attached to another moiety, its name may be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

The terms "halo," "halogen," and "halide" are used interchangeably and refer to fluorine, chlorine, bromine, and iodine.

In this description, the arylene is a divalent organic fragment that is derived from an aromatic or heteroaromatic hydrocarbon (arene or heteroarene) by removing two hydrogen atoms from the aromatic or heteroaromatic hydrocarbon, preferably from different carbon and/or hetero atoms. One example is a (hetero) aromatic hydrocarbon that has had hydrogen atoms removed from two, preferably adjacent, hydrogen-bearing atoms (in case of aromatic hydrocarbon two carbon atoms, in case of heteroaromatic hydrocarbons two atoms selected from carbon and heteroatoms). An aromatic hydrocarbon or arene (or sometimes aryl hydrocarbon) is a cyclic hydrocarbon comprising only sp²-hybridized carbon atoms, leading to a delocalized π-system. Such (hetero) aromatic units may as well improve the charge transport or charge capture properties of the metal organic coordination compounds. Yet, preference is given to (hetero) aromatic groups with sufficiently high triplet energy to confine the excitation to the central Europium atom and, again, preference is given to relatively strong electron-donating aromatic groups without heteroatoms or with only oxygen or nitrogen as heteroatoms. Each (hetero) aromatic group(s) preferably contain(s) 1 to 5, more preferably 1 to 4, most preferably 1, 2 or 3, preferably fused or annelated, ring structures, preferably (hetero) aromatic) ring structures that contain 0 or 1 non (hetero)aromatic ring, like in a benzofuran group. An alkylene is a divalent organic fragment that is derived from an alkyl group by removing one additional substituent.

The term "alkyl" refers to and includes both straight and branched alkyl chain radicals and can furthermore also include cycloalkyl radicals. Preferred alkyl groups are those containing from one to fifteen, preferably one to ten, more preferably one to five carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group is optionally substituted, e.g., by halogen, preferably fluorine, or cycloalkyls.

The term "cycloalkyl radical" refers to and includes monocyclic, polycyclic, and spiro alkyl radicals. Preferred cycloalkyl groups are those containing 3 to 12, preferably 3 to 8 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group is optionally substituted, e.g., by halogen, deuterium, alkyl or heteroalkyl.

The terms "heteroalkyl" or "heterocycloalkyl" refer to an alkyl or a cycloalkyl radical, respectively, having at least one carbon atom replaced by a heteroatom. Preferably the at least one heteroatom is selected from O, S, N, P, B, and Si, more preferably O, or N. Preferably 1 to 5, more preferably 1 to 3, most preferably 1 or 2 heteroatoms are present in the radical. The radical can be covalently linked with the remainder of the molecule via a carbon or heteroatom (e.g., N). Additionally, the heteroalkyl or heterocycloalkyl group is optionally substituted as indicated for alkyl and cycloalkyl.

The term "alkenyl" refers to and includes both straight and branched chain alkene radicals. Alkenyl groups are essentially alkyl groups with more than one carbon atom that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one, preferably 1 to 5, more preferably 1 to 3, most preferably 1 or 2 carbon atoms replaced by a heteroatom. Preferably, the at least one heteroatom is selected from O, S, N, P, B, and Si, more preferably O, S, or N. Preferred alkenyl/cycloalkenyl/heteroalkenyl groups are those containing two/three/one to fifteen carbon atoms. Additionally, the alkenyl, cycloalkenyl, or heteroalkenyl group is optionally substituted, as indicated above.

The terms "aralkyl" or "arylalkyl" are used interchangeably and refer to an alkyl group that is substituted with an aryl group. Additionally, the aralkyl group is optionally substituted, as indicated for alkyl and aryl.

The term "heterocyclic group" refers to and includes aromatic and non-aromatic cyclic radicals containing at least one, preferably 1 to 5, more preferably 1 to 3 heteroatoms. Preferably the at least one heteroatom is selected from O, S, N, P, B, and Si, more preferably O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted, e.g., by halogen, deuterium, alkyl or aryl. The heterocyclic group can be covalently linked with the remainder of the molecule via carbon and/or heteroatoms, preferably one carbon or nitrogen atom. The heterocyclic group can as well be linked with two carbon and/or heteroatoms with the remainder of the molecule.

The term "aryl" refers to and includes both single-ring aromatic hydrocarbon groups and polycyclic aromatic ring systems. The polycyclic rings may have two or more rings in which two carbons are common to two adjoining rings (the rings are "fused") or wherein one carbon is common to two adjoining rings (e.g., biphenyl) wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl, and radialene. Most preferred is phenyl that can be substituted by non-aromatic groups. Additionally, the aryl group is optionally substituted, e.g., by halogen, alkyl, heteroalkyl, or deuterium. The aryl group is connected to the remainder of the ligand via one or two carbon atoms.

The term "heteroaryl" refers to and includes both single-ring aromatic groups and polycyclic aromatic ring systems that include at least one heteroatom. The heteroatoms include, but are not limited to and are preferably selected from O, S, N, P, B, and Si. In many instances, O, S, or N are the preferred heteroatoms. Hetero-single ring aromatic systems are preferably single rings with 5 or 6 ring atoms, and the ring can have from one to five/six, preferably 1 to 3 heteroatoms. The hetero-polycyclic ring systems can have two or more rings in which two atoms are common to two adjoining rings (the rings are "fused") or wherein one carbon is common to two adjoining rings (e.g., bipyridine) wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-Oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl.

Generally, aryl and heteroaryl groups with triplet level > 2.5 eV or more preferably >2.6 eV or most preferably > 2.7 eV such as the groups derived from benzene, furan, dibenzofuran, dibenzoselenophene, carbazole, imidazole, pyridine, pyrazine, pyrimidine, triazine, and the respective aza-analogs of each thereof are of particular interest. There are many possible ways to probe the triplet energy level of an organic molecule. A simple way is to use suitable quantum mechanical calculations. A more experimental way takes the onset of the phosphorescence spectrum, which is usually detected using gated spectroscopy, as pioneered by Romanovskii et al. "Phosphorescence of π-conjugated oligomers and polymers." Physical Review Letters 84.5 (2000): 1027. In combination with high triplet energy, generally preference is given to benzene or low polarizable, hard heteroaryl groups, such as 1,3,4-Oxadiazole, furan, thiophene, 1,2,4-triazole, 1,2,3-triazole, and pyrazole carbazole, dibenzofuran, and benzofuran groups.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted, with one or more (general) substituents, preferably the substituents mentioned above.

Preferably, the (general) substituents are selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof with the number of carbon atoms and heteroatoms as defined above for the respective term. Furthermore, one or two substituents can be selected from polymer chains which can be covalently linked with the remainder of the molecule by a suitable organic spacer. Therefore, the cyclic organic ligand can be covalently linked with a polymer chain or a polymer backbone.

In some instances, the preferred general substituents are selected from the group consisting of deuterium, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term.

In yet other instances, the more preferred general substituents are selected from the group consisting of deuterium, alkyl, cycloalkyl, aryl, heteroaryl, and combinations thereof with the number of carbon atoms and heteroatoms as defined above for the respective term.

The terms "substituted" and "substitution" refer to a substituent other than H that is bonded to the relevant position, e.g., a carbon or nitrogen. For example, when R represents mono-substitution, then one R must be other than H (i.e., a substitution). Similarly, when R represents di-substitution, then two of R must be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

Any type of substituent can replace a hydrogen atom in an organic or heterorganic group of compound (a) or (b) or the second organic layer above, as long as it results in a chemical compound which is stable under conditions that occur in an OLED display device or organic electronic device and which does not chemically react with other compounds and components of the OLED display device or organic electronic device.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule.

In some instances, a pair of adjacent residues can be optionally joined (i.e., covalently linked with each other) or fused into a ring. The preferred ring formed therewith is a five-, six-, or seven-membered carbocyclic or heterocyclic ring, including both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, or 2,3-positions in a phenyl, or 1,2-positions in a piperidine, as long as they can form a stable fused ring system. In some instances, a pair of non-adjacent substituents can be optionally joined usually by an, at least partial, alkane or heteroalkene chain of atoms, thereby forming another macrocyclic ring system as part of the macrocyclic ring present as part of the coordination compound. In some instances, a pair of substituents present on the same carbon atom can be optionally joined, i.e., into an aryl or heteroaryl group, thus, forming a spiro linkage on said particular carbon atom.

In this description, the term organyl refers to any chemically stable organic arrangement of atoms where one or more hydrogen atom has been removed such as to use those free vacancies to covalently link the organic group with another molecular entity. Thus, the term organyl encompasses the majority of the above defined organic groups e.g., fluorine, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term. The term organyl shall especially as well encompass sufficiently chemically stable negatively charged species, such as anions, or anionic side groups.

Organic groups are derived or formed by removing one or more hydrogen atoms from organic molecules containing at least a corresponding number of hydrogen atoms. For example, benzene results in phenyl or phenylene groups by removing one or two hydrogen atoms, resulting in a monovalent or divalent organic group.

Suitable organic molecules and groups are as identified above, e.g. alkyl, aryl, heteroaryl groups.

In this description, an electroluminescent coordination compound is any material that is able to emit light upon electrical excitation, resulting from recombination of electrons and holes. It shall be irrelevant in this context whether the recombination of the electrons and holes takes place directly on the electroluminescent compound or first an excitation is formed on a different compound and subsequently transferred to the electroluminescent compound. Further, it shall be irrelevant in this context whether the light emitted is visible for the human eye or not. Especially, compounds emitting infrared and near ultra-violet emission shall be explicitly included. Further, the mixture comprising the electroluminescent coordination compound does not necessarily have to be used in an electronic device but, for example, may be used as a dye or a contrast enhancement medium for magnetic resonance tomography. In particular it may be used for down-converting high energy photons after optical excitation.

In the OLED community, the emission is usually classified as fluorescence if it originates from an optically allowed (spin-conserving) transition and decays within a few nanoseconds, such as the transition from the first excited singlet state to the singlet ground state, or, as phosphorescence if the emission originates from a spin-forbidden transition and decays with a few micro-milliseconds, such as from the first excited triplet state to the singlet ground state. The emission from the first electronically excited divalent Europium results from an optically allowed spin-conserving d-f transition, which, due to small overlap between the 5d and 4f orbitals, has a rather long excited state lifetime of 1.2 µs (compared to typical fluorescence). Thus, it clearly is neither fluorescent, nor phosphorescent in the typical context used in OLED community. It should correctly be referred to as emission from an intrametallic transition.

An aromatic hydrocarbon or arene (or sometimes aryl hydrocarbon) is a cyclic hydrocarbon comprising only sp²-hybridized carbon atoms, leading to a delocalized π-system. An alkylene is a divalent organic fragment that is derived from an alkyl group by removing one additional substituent.

The term "acyl group" refers to a functional group with formula (2-1). 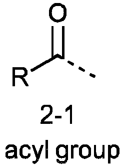 wherein R is bound to the carbon atom with a single bond, the carbon and oxygen atoms are joined by a double bond and the dashed line indicates the linkage of acyl groups to other groups to form a molecule. Examples of molecules (2-2) to (2-6) containing acyl groups are aldehydes, ketones, esters, amides, chloranhydrides, etc.

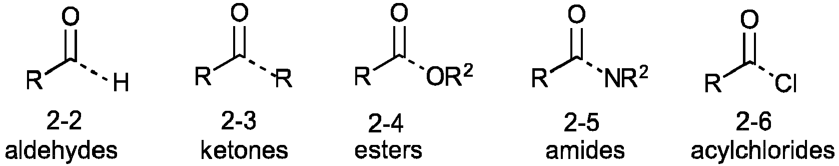

The term "acyl group" also refers to groups named acyl cation (2-7) and acyl radical (2-8).

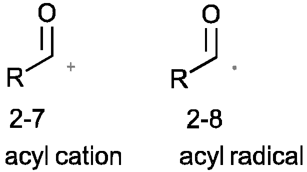

Acylation is a broad class of chemical reactions in which an acyl group (R-C=O) is added to another molecule or group via the dashed line in the formula (2-1). At the same time, acylation can be described as reaction in which the substrate is added to acyl group, particularly to the sp2-hybridized carbon atom of acyl group. A transformation of (2-9) into (2-10) illustrates the acylation reaction on example of sodium 12-oxido-1-carbadodecaborate (2-9).

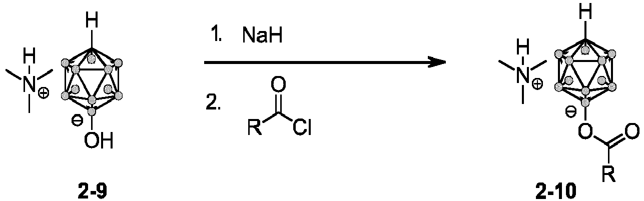

The compound undergoing acylation according to the invention is alcohol 2-9. The compound providing the acyl group is called the acylating agent. In the example above, the acylation agent is acyl chloride. The chloride group removed from the acylation agent during the acylation reaction is called a "leaving group". Besides chloride, acylation agents may contain other leaving groups, such as but not limiting to iodide, bromide, floride, tosylate, mesylate, triflate or other leaving groups.

The term "alkyl group" refers to a functional group formed by removing a hydrogen atom from an alkane. Alkylation is a broad class of chemical reactions in which an alkyl group (R) is added to a substrate. In contrast to the acylation reaction, in which the reaction involves the sp2-hybridized carbon atom of acyl group, the alkylation involves the sp3-hybridized carbon atom of alkyl group.

Arylation is a broad class of chemical reactions in which an aryl or hetero-aryl group, both unsubstituted or substituted with other groups, is added to a substrate.

The present invention discloses acylation, arylation and alkylation of hydroxyl groups attached to carba-closo-dodecaborate.

Reactions below exemplify alkylation, arylation and acylation of molecules containing hydroxyl groups.

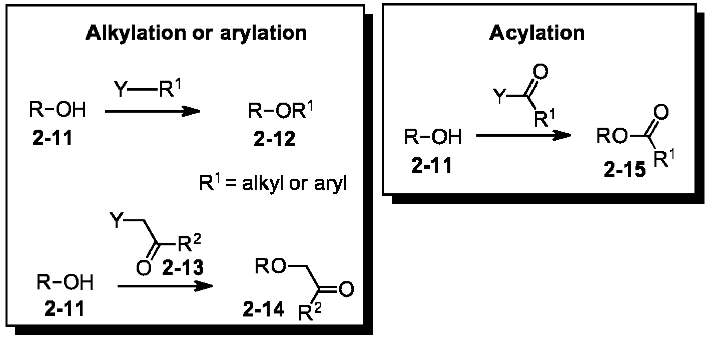

It is noticeable, the transformation 2-11 4 2-14 is the alkylation reaction despite of the fact that the compound 2-13 contains acyl group, because the acyl group is not involved in the reaction. The transformation of 2-9 into 2-16 exemplifies the alkylation of the 12-hydroxy-1-carbadodecaborate.

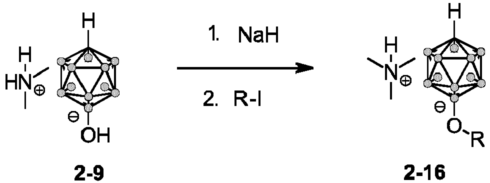

In the example above, the compound R-I providing the alkyl group R is the alkylation agent.

The term "alkylation reaction" also refers to reactions in which an alkyl group to be added to the substrate may optionally contain other functional groups or substituents..

For example, the transformation of 2-9 into 2-18 illustrates the alkylation of the divalent alkylation agent 2-16 of two 12-hydroxy-1-carbadodecaborate molecules.

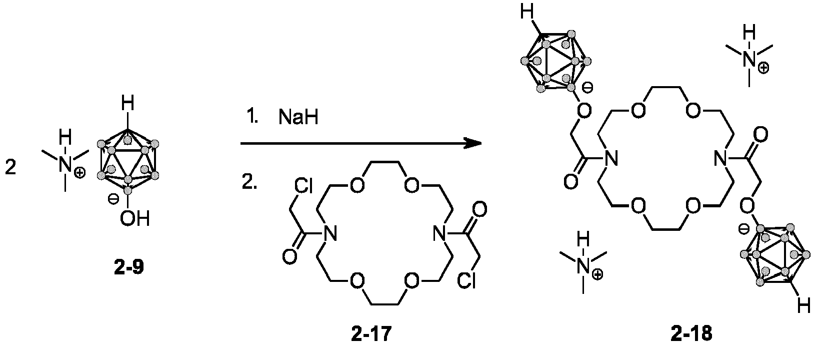

It should be emphasized that despite of the fact that the molecule 2-18 contains two acyl groups, the transformation of 2-9 into 2-18 is the example of the alkylation but not the acylation reaction, because the substrate 2-9 is added to the sp3-hybridized carbons, which is the indicator of the alkylation reaction.

In the alkylation and acylation reactions 2-11 → 2-12, 2-11 → 2-14, 2-11 → 2-16, the Y group which was removed during the reaction from the alkylation and acylation agents is called the "leaving group". As such, in the alkylation reaction 2-9 → 2-16, the iodide group removed during the reaction from the acylation agent R-I is called the "leaving group". The chloride group in the compound 2-17 is the leaving group, as well. Besides the chloride and iodide, alkylation agents may preferably contain other leaving groups, such as, but not limiting to, bromide, fluoride, tosylate, mesylate, or triflate.

The term "aryl" refers to and includes both single-ring aromatic hydrocarbon groups and polycyclic aromatic ring systems. The polycyclic rings may have two or more rings in which two carbons are common to two adjoining rings (the rings are "fused") or wherein one carbon is common to two adjoining rings (e.g., biphenyl) wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl, and radialene. Most preferred is phenyl that can be substituted by non-aromatic groups. Additionally, the aryl group is optionally substituted, e.g., by halogen, alkyl, heteroalkyl, or deuterium. The aryl group is connected to the remainder of the ligand via one or two carbon atoms.

The term "heteroaryl" refers to and includes both single-ring aromatic groups and polycyclic aromatic ring systems that include at least one heteroatom. The heteroatoms include but are not limited to and are preferably selected from O, S, N, P, B, and Si. In many instances, O, S, or N are the preferred heteroatoms. Hetero-single ring aromatic systems are preferably single rings with 5 or 6 ring atoms, and the ring can have from one to five/six, preferably 1 to 3 heteroatoms. The hetero-polycyclic ring systems can have two or more rings in which two atoms are common to two adjoining rings (the rings are "fused") or wherein one carbon is common to two adjoining rings (e.g., bipyridine) wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted, with one or more (general) substituents, preferably the substituents mentioned below or above.

Preferably, the (general) substituents are selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof with the number of carbon atoms and heteroatoms as defined above for the respective term. Furthermore, one or two substituents can be selected from polymer chains which can be covalently linked with the remainder of the molecule by a suitable organic spacer. Therefore, the cyclic organic ligand can be covalently linked with a polymer chain or a polymer backbone.

The terms "substituted" and "substitution" refer to a substituent other than H that is bonded to the relevant position, e.g., a carbon or nitrogen. For example, when R represents mono-substitution, then one R must be other than H (i.e., a substitution). Similarly, when R represents di-substitution, then two of R must be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule.

In this description, the term organyl (as well as organic group) refers to any chemically stable organic arrangement of atoms where one or more hydrogen atom has been removed such as to use those free vacancies to covalently link the organic group with another molecular entity. Thus, the term organyl encompasses the majority of the above defined organic groups e.g., alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term. The term organyl shall especially as well encompass sufficiently chemically stable negatively charged species, such as anions, or anionic side groups. Hydocarbon groups are organyl groups made up of carbon and hydrogen.

### EXAMPLES

The examples set forth herein are illustrative and not exhaustive. Any of the examples may be combined with any other example (or combination of examples), unless explicitly stated otherwise. The foregoing description of one or more implementations provides illustration and description but is not intended to be exhaustive or to limit the scope of aspects to the precise form disclosed. Modifications and variations are possible in light of the above teachings or may be acquired from practice of various aspects. Any of the above-described embodiments may be combined with any (other) example as mentioned below (or combination of examples), unless explicitly stated otherwise.

### General remarks

The following procedures were, unless indicated otherwise, carried out under an inert atmosphere in oven dried glassware. The solvents, starting materials and reagents can be purchased from commercial sources and are, unless otherwise stated, used without further purification.

### Synthesis of starting materials

**Trimethylammonium 12-Hydroxy-1-carbadodecaborate** was synthesized according to a known literature procedure by B. Grüner et al. Collect. Czech. Chem. Commun. 2002, 67, 953-964.

**Trimethylammonium 12-hydroxy-1-methylcarbadodecaborate** was synthesized in analogy to the procedure by B. Grüner *et al.,* using Cesium 1-methylcarbadodecaborate as starting material.

**Trimethylammonium 7,12-dihydroxy-1-carbadodecaborate** was synthesized in analogy to **Trimethylammonium 12-Hydroxy-1-carbadodecaborate** using an elongated reaction time of 17 h.

**2-Chloro-1-[16-(2-chloroacetyl)-1,4,10,13-tetraoxa-7,16-diaza-7-cyclooctadecyl]-1-ethanone** was synthesized according to a know literature procedure by M. Pietraszkiewicz et al. Incl. Phenom. Macrocycl. Chem. 1992, 14, 237-245.

### General procedure for the preparation of Sodium oxido-1-carbadodecaborates

The corresponding Trimethylammonium hydroxy-1-carbadodecaborate was dissolved in a suitable solvent and treated with an excess of sodium hydride. The mixture was stirred at room temperature. The mixture was filtered, the residue washed with small amounts of the used organic solvent and the filtrate concentrated in vacuum to dryness. The remaining sodium oxido-1-carbadodecaborate was used without further purification.

### Sodium 12-oxido-1-carbadodecaborate

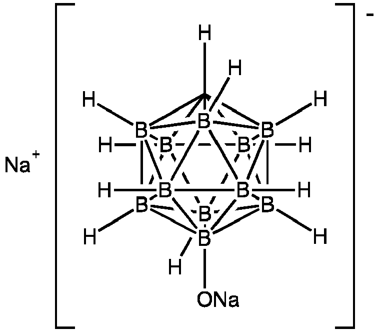

The title compound was prepared according to the general procedure using 3 eq. of NaH and THF (0.25 M) as solvent. After removal of the solvent, the product was yielded as an off-white powder.

### General procedure A: Alkylation/arylation of Sodium oxido-1-carbadodecaborates

A solution of the corresponding sodium oxido-1-carbadodecaborate (1 eq) in a suitable solvent (0.25 M) was added slowly to the alkylation/arylation reagent. The solution was stirred at rt or under reflux for 15 h. The reaction was quenched with NaCl_{aq}. (half-sat.), the layers separated, and the aqueous layer extracted with Et₂O or EtOAc. The combined organic layers were concentrated in vacuum. The residue was dissolved in H₂O or a boiling mixture of H₂O/EtOH and treated with Trimethylamine hydrochloride (3 eq). The mixture was cooled to 0 °C for 1 h, the precipitate filtered-off, washed with H₂O and dried in vacuum. The product is obtained as Trimethylammonium salt.

### General procedure B: "one-pot" alkylation/arylation of Trimethylammonium 12-hydroxy-1-carbadodecaborate

Trimethylammonium 12-hydroxy-1-carbadodecaborate (1 eq) was dissolved in a suitable solvent (0.25 M) and treated with Sodium hydride (3 eq; 60 % dispersion in mineral oil) in portions. The mixture was stirred at rt for 2 h at rt. The mixture is concentrated to dryness in vacuum. The residue is re-dissolved, and the obtained mixture added to the alkylation reagent. The mixture is stirred at rt or under reflux for 15 h. The reaction was quenched with NaClaq. (half-sat.), the layers were separated, and the aqueous layer extracted with EtOAc. The combined extracts were washed with NaCl_{aq}. (sat.), the washing-layers re-extracted with EtOAc, and the combined organic layers concentrated in vacuum to dryness. The residue was dissolved in H₂O or a boiling mixture of H₂O/EtOH and treated with Trimethylamine hydrochloride (3 eq). The solvents were removed in vacuum and the residue washed with H₂O and dried in vacuum. If needed, the crude product was purified by recrystallization from H₂O/EtOH.

### EXAMPLE 1: Synthesis of Trimethylammonium 12-Methoxy-1-carbadodecaborate

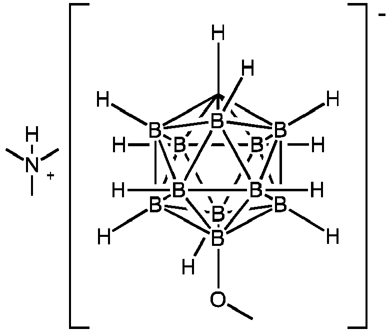

The title compound was prepared according to general procedure A using 3.14 mmol (1 eq.) of Sodium 12-oxido-1-carbadodecaborate and 9.42 mmol (3 eq.) Methyl iodide in THF (20 mL). The crude product was purified by recrystallization from water, yielding the title compound as colourless crystals in in 77%.

¹H-NMR (60 MHz, CD₃CN): δ (ppm) = 3.19 (s, 3 H), 2.81 (s, 9 H), 2.11 (br. s, 1 H), 1.53 (br. s, 10 H); ¹¹B-NMR (CD₃CN): δ (ppm) = 7.62 (br. s, 1 B), -12.18 (s, 10 B); MS (ESI): m/z = -173.2 [M-Me₃NH]⁻; EA: calc.: C 25.76%, H 10.37%, N 6.01%; found C 25.68%, H 10.10%, N 5.85%.

### EXAMPLE 2: Synthesis of Trimethylammonium 12-Ethoxy-1-carbadodecaborate

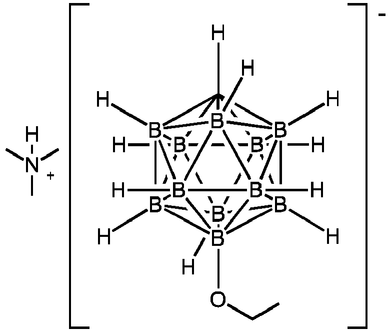

The title compound was prepared according to general procedure A using 0.27 mmol (1 eq.) of sodium 12-oxido-1-carbadodecaborate and 1.25 mmol (4 eq.) Ethyl iodide in THF (20 mL). The crude product was purified by recrystallization from water, yielding the title compound as colourless crystals in 23%.

MS (ESI): m/z = -187.3 [M-Me₃NH]⁻

### EXAMPLE 3: Synthesis of Trimethylammonium 12-Methoxy-1-Methylcarbadodecaborate

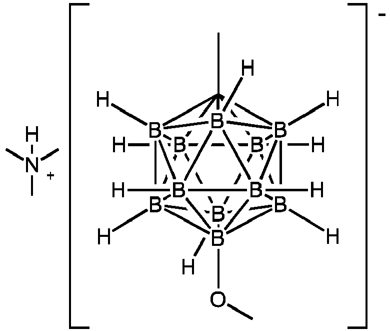

The title compound was prepared according to general procedure B using 0.91 mmol (1 eq.) Trimethylammonium 12-hydroxy-1-methylcarbadodecaborate, 2.72 mmol (3 eq.) NaH, 2.72 mmol (3 eq.) Methyl iodide and 2.72 mmol (3 eq.) Trimethylammonium chloride. The product was yielded in 63% as off-white powder and was used without further purification.

¹H-NMR (60 MHz, acetone-d6): δ (ppm) = 9.24 (br. s, 1 H), 3.19 (s, 3 H), 3.09 (s, 9 H), 1.68 (br. s, 10 H), 1.58 (s, 3 H); ¹¹B-NMR (acetone-d6): δ (ppm) = 8.63 (br. s, 1 B), -8.63 (s, 10 B); MS (ESI): m/z = -187.2 [M-Me₃NH]⁻.

### EXAMPLE 4: Synthesis of Sodium 7,12-dimethoxy-1-carbadodecaborate

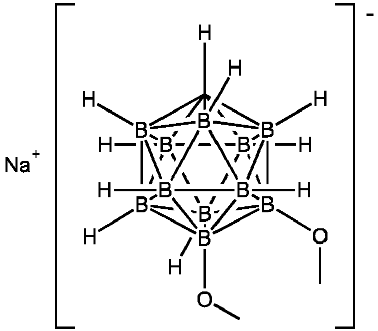

0.15 mmol (1 eq.) of Trimethylammonium 7,12-dihydroxy-1-carbadodecaborate were dissolved in THF (1 ml). The solution was stirred at rt and 0.60 mmol (4 eq.) of sodium hydride (60 % dispersion in mineral oil) was added. The mixture was stirred for 5 h. The mixture was filtered, the residue washed with THF, and the filtrate concentrated in vacuum to dryness. The residue was redissolved in THF (1 ml) and 0.60 mmol (4 eq.) of methyl iodide was added via syringe. Stirring was continued for 16 h at rt. The reaction was quenched with brine. The layers were separated, the aqueous layer extracted with EtOAc (3x 2 ml) and the combined organic layers concentrated in vacuum to dryness. The title compound was yielded as colorless crystals in 86% and was used without further purification.

¹H-NMR (60 MHz, acetone-d6): δ (ppm) = 3.34 (s, 9 H), 3.22 (s, 3 H), 3.11 (s, 3 H), 1.89 (br. s, 1 H), 1.27-0.87 (m, 8 H); ¹¹B-NMR (acetone-d6): δ (ppm) = 5.92 (s, 1 B), 5.25 (s, 1 B), - 13.35 - -31,97 (m, 9 B); MS (ESI): m/z = -203.2 [M-Na]⁻.

### EXAMPLE 5: Synthesis of Trimethylammonium 12-(2-nitrophenoxy)-1-carbadodecaborate

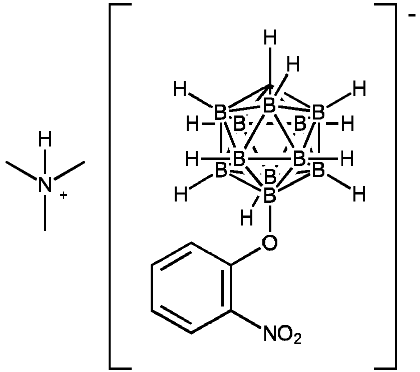

The title compound was prepared according to general procedure B using 0.46 mmol (1 eq.) of Trimethylammonium 12-hydroxy-1-carbadodecaborate, 1.37 mmol (3 eq.) Sodium hydride, 0.50 mmol (1.1 eq.) of 2-Fluoronitrobenzene in DMF (6.5 ml). The Trimethylammonium salt was precipitated using 1.37 mmol (3 eq.) Trimethylammonium chloride. The crude product was purified by recrystallization from H₂O/EtOH to yield the title compound in 50% as colourless crystals.

¹H-NMR (60 MHz, CDCl₃): δ (ppm) = 7.85 - 7.60 (m, 1 H), 7.46 - 7.30 (m, 2 H), 7.20 - 7.00 (m, 1 H), 2.95 (d, J = 5.19 Hz, 9 H), 2.14 (br. s, 1 H), 1.79 - 1.44 (m, 10 H); MS (ESI): m/z = -280.2 [M-Me₃NH]⁻.

### EXAMPLE 6: Synthesis of Trimethylammonium 2-(1-carbadodecaboryl-12-oxy)-1-{16-[2-(1 -carbadodecaboryl-12-oxy)acetyl]-1,4,10,13-tetraoxa-7,16-diazacyclo-octadec-7-yl}ethan-1-one

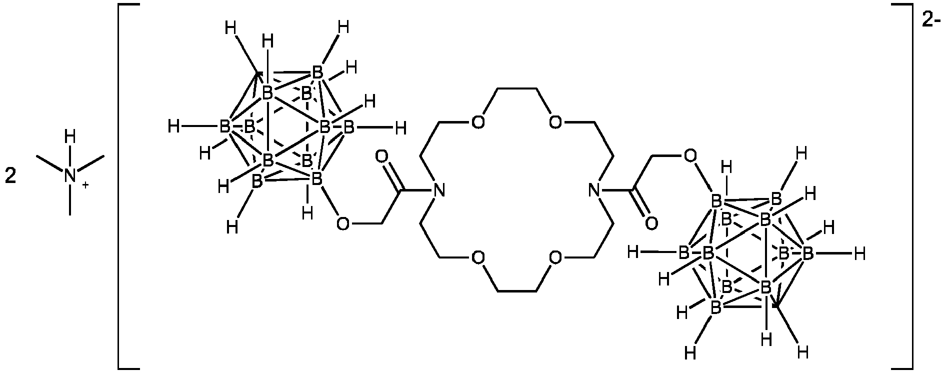

The title compound was prepared according to general procedure A using 1.54 mmol of 2-Chloro-1-[16-(2-chloroacetyl)-1,4,10,13-tetraoxa-7,16-diaza-7-cyclooctadecyl]-1-ethanone, 3.39 mmol of Sodium 12-oxido-1-carbadodecaborate and 6.25 mmol Trimethylammonium chloride in THF (25 ml). The crude product was purified by recrystallization from EtOH/H₂O (1:1) to yield the title compound as a colourless powder in 88%.

¹H-NMR (60 MHz, DMSO-d6): δ (ppm) = 9.31 (br. s, 2 H), 3.78 (s, 4 H), 3.64-3.21 (m, 24 H), 2.77 (s, 18 H), 2.13 (br. s, 2 H),1.66-1.06 (m, 20 H); ¹¹B-NMR (DMSO-d6): δ (ppm) = 5.42 (br. s, 2 B), -17.09 (br. s, 20 B); MS (ESI): m/z = -330.34 [M-2 Me₃NH]²⁻, -661.8 [M-2 Me₃NH+H]⁻.

## Claims

1. A process for the preparation of substituted carba-closo-dodecaborate derivative of general formula **(1-1),** comprising two major steps:
a) reacting a starting compound of general formula **(1-2),** containing at least one OH or OD group, with an inorganic or organic base, in a solvent, to form an intermediate compound of general formula **(1-3),** in which the OH and OD groups present in **(1-2)** are converted to OX groups,
b) followed by reacting a mono-valent, divalent or multi-valent derivatization reagent with general formulae **Y-R⁶**, **Y-R⁴-Y**, or **YₙR⁵**, respectively, in a solvent with the compound of general formula **(1-3)** to obtain the substituted 1-carba-closo-dodecaborate derivative with the general formula **(1-1),** 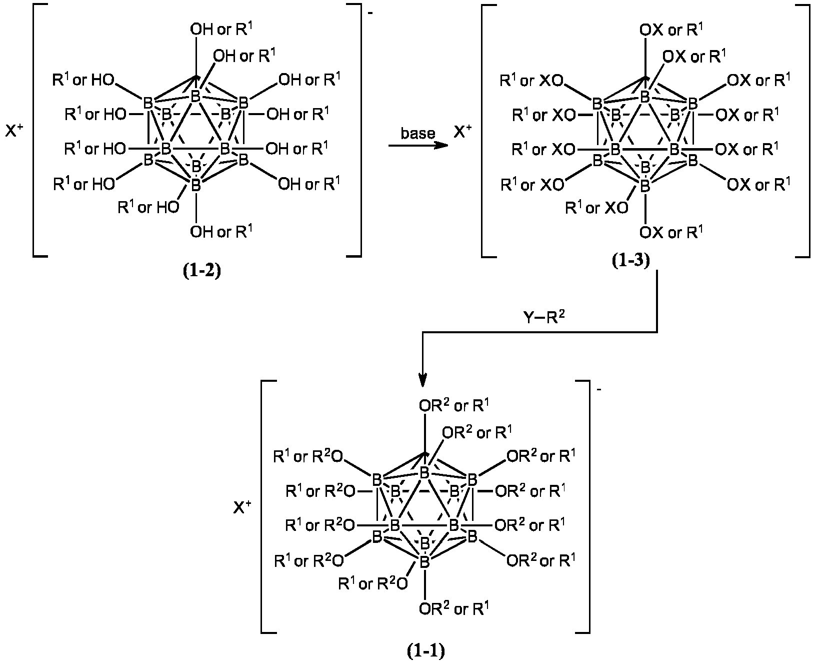 in which the OX groups present in **(1-3)** are converted to OR² groups,
with at least or exactly one OH or OD group present in the starting compound of general formula **(1-2)** which undergoes alkylation, acylation or arylation reactions, and with the non-reacted OH groups and all groups R¹ remaining unreacted during the process steps a) and b), with
• **R¹** being identical or different in each occurrence selected from hydrogen, deuterium, iodine, bromine, chlorine, fluorine, an alkyl, an alkoxy or an aryl group, preferably hydrogen or a methyl group, most preferably hydrogen;
• **X+ or X** being a monocation identical or different in each occurrence selected from lithium, sodium, potassium, caesium, rubidium, silver, ammonium or alkyl ammonium, or half equivalents of a dication selected from: beryllium, magnesium, calcium, strontium or barium, preferably lithium, sodium or potassium, more preferably sodium;
• **Y** being a monovalent leaving group selected from iodide, bromide, chloride, fluoride, tosylate, mesylate, triflate or other leaving groups,
• **R²** being a monovalent organic group **R⁶**, a divalent organic group **R⁴** being covalently linked to a second carba-*closo*-dodecaborate derivative of general formula **(1-1)** or a polyvalent organic group **R⁵** being covalently linked to (n-1) further carba-closo-dodecaborate derivatives of general formula **(1-1);**
• **R⁴** being a divalent organic group being identical or different in each occurrence and derived from an organic molecule containing at least two hydrogen atoms by removing two hydrogen atoms, preferably from an aliphatic or aromatic hydrocarbon than can contain cyclic or heterocyclic groups and substituents;
• **R⁶** being a monovalent organic group being identical or different in each occurrence and derived from an organic molecule containing at least one hydrogen atom by removing a hydrogen atom, preferably alkyl, aryl, heteroaryl, or acyl;
• **R⁵** being a polyvalent organic group being identical or different in each occurrence and derived from an organic molecule containing at least n hydrogen atoms by removing n hydrogen atoms, preferably from an organic polymer containing side groups from which the hydrogen atoms are removed; n being a number of at least 3, preferably at least 10, more preferably at least 50;
wherein in formula **(1-2), R¹** can replace **OH**, in formula **(1-3), OX**, in formula **(1-1), OR²** in the respective positions of the carba-closo-dodecaborate structure.

2. The process according to claim 1, wherein the starting compound of general formula **(1-2)** has only a single OH group, preferably in the vertex 12 position, and all other 11 groups of R¹ are hydrogen, and with X⁺ present in the starting compound of general formula (1-2) being alkali or tri-alkylammonium, preferably tri-alkylammonium, and with X and X⁺ present in the intermediate compound of general formula (1-3) being alkali or tri-alkylammonium, preferably bis-sodium, wherein formula **(1-2)** and **(1-3)** preferably are as follows:

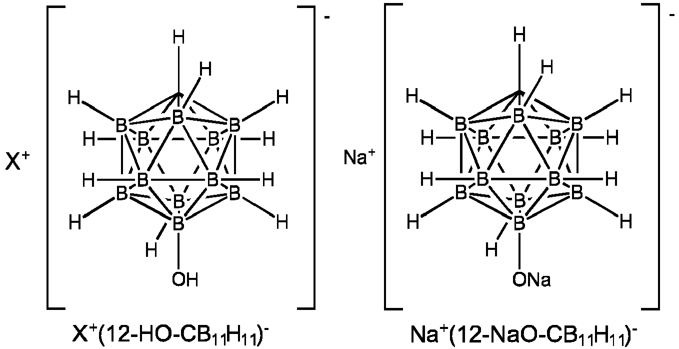

3. The process according to claim 1 or 2, wherein the solvent is an aprotic solvent, preferably selected from toluene, diethyl ether, dioxane, dimethylsulphoxide, acetonitrile, dimethylformamide (DMF), or their mixtures, more preferably from DMF and THF, most preferably from THF.

4. The process according to any one of claims 1 to 3, wherein the derivatization agent **Y-R²** is selected from Cl-CH₂-CO-NH-**R³**, Br-CH₂-CO-NH-**R**³, I-CH₂-CO-NH-**R³**, Cl-CH₂-CO-O-**R³**, Br-CH₂-CO-O-**R³**, I-CH₂-CO-O-R³, Cl-CH₂-CO-R³, Br-CH₂-CO-**R³**, I-CH₂-CO-**R³**, Cl-CO-**R³**, Br-CO-**R³**, with **R³** representing any covalently linked monovalent organic group formed by removing a hydrogen atom from an organic molecule containing at least one hydrogen atom.

5. The process according to any one of claims 1 to 4 wherein the base is selected from alkali hydroxides, alkali alkoxides, alkali bis(trimethylsilyl)amides, alkali diisopropylamides, organolithium reagents, trialkylamines, or organic superbases, such as aminophosphines, phosphazenes, phosphanes, carbodiphosphoranes, amidines, guanidines, multicyclic polyamines, bispidines, or their mixtures, preferably from alkali hydrides, most preferably from sodium hydride.

6. The process according to any one of claims 1 to 5, wherein the groups **R⁴**, **R⁵** and **R⁶** are covalently linked to Y or the substituted carba-closo-dodecaborate derivative of general formula **(1-1)** via a group (**R⁷**)₂N-C(=O)-(CH₂)ₘ--- or via a group (**R⁷**)2N-(CH₂)ₘ-- wherein m being a number from 1 to 4, (**R⁷**)₂ is the remainder of the groups **R⁴**, **R⁵** and **R⁶** and --- is the linkage to the oxygen of the carba-closo-dodecaborate derivative, and wherein the two groups the groups **R⁷** can be the same or different and can be covalently linked with each other.

7. The process according to claims 6, wherein R⁴ is covalently linked to Y or the substituted carba-closo-dodecaborate derivative of general formula **(1-1):** via two groups N-C(=O)-(CH₂)ₘ--- or via a group (**R⁷**)2N-(CH₂)ₘ—with m being a number from 1 to 4, and the two nitrogen atoms thereof are covalently linked with each other via two hydrocarbon chains which can be interrupted by one or more non-adjacent heteroatoms, independently selected from NR⁸, O, S, BR⁸ with R⁸ being hydrogen or a monovalent organic group derived from an organic molecule containing at least one hydrogen atom by removing a hydrogen atom, preferably alkyl, aryl, heteroaryl, or acyl, so that a heterocyclic group is formed.

8. The process according to claim 7, wherein the heterocyclic group contains 12 to 48, preferably 15 to 24, more preferably 18 to 20 ring-forming atoms of which 2 to 4 atoms are nitrogen atoms, of which 2 to 4 atoms are oxygen and/or sulphur atoms, with the proviso that in total 4 to 6 heteroatoms are present in the ring-forming atoms, and the heteroatoms are non-adjacent.

9. The process according to any one of claim 1 to 8, wherein organic group R⁶ is selected from s1 to s42, with the dashed line indicating the linkage to Y or the oxygen of the substituted carba-closo-dodecaborate derivative of general formula **(1-1)** 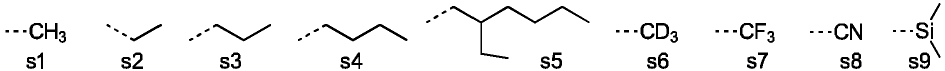 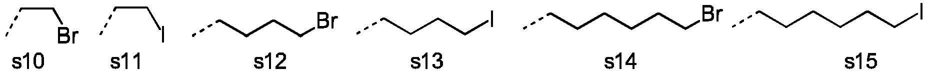 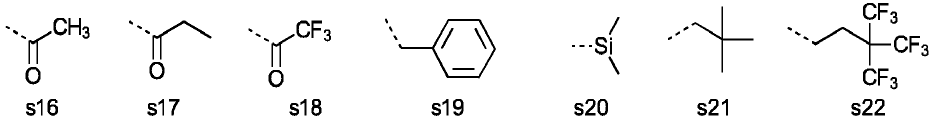 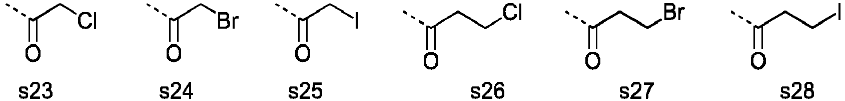 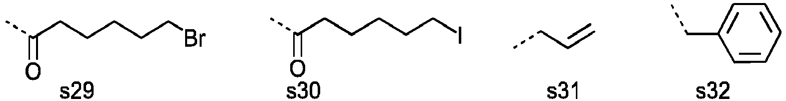 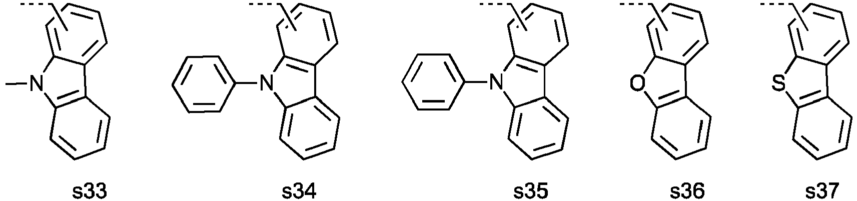 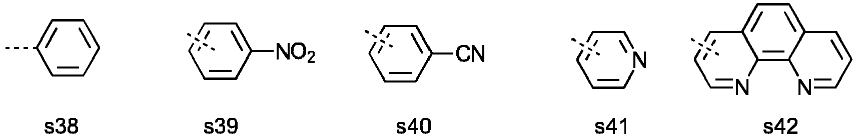 and organic group R⁴ is selected from m1 to m5, with the dashed line indicating the linkage to Y or the oxygen of the substituted carba-*closo*-dodecaborate derivative of general formula **(1-1)** 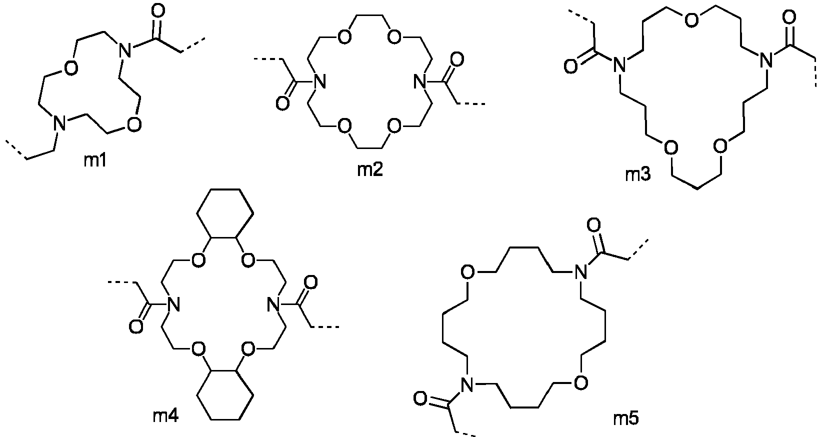 and **YₙR⁵** is a multivalent organic compound having a molecular weight of more than 1500 g/mol, and wherein the number **n** of leaving groups **Y** is greater than two, preferably greater than ten, most preferably, greater than fifty, such that a multitude of substituted carba-closo-dodecaborates according to formula (1-1) is covalently attached to a linear or branched polymer backbone.

10. The process according to claim 9, wherein the multivalent organic group **R⁵** is selected from p1 to p4, with n being greater than two, preferably greater than ten, most preferably greater than fifty, with k being a number from 1 to 4, and the dashed line indicating the linkage to the oxygen of the substituted carba-*closo-*dodecaborate derivative of general formula **(1-1)**

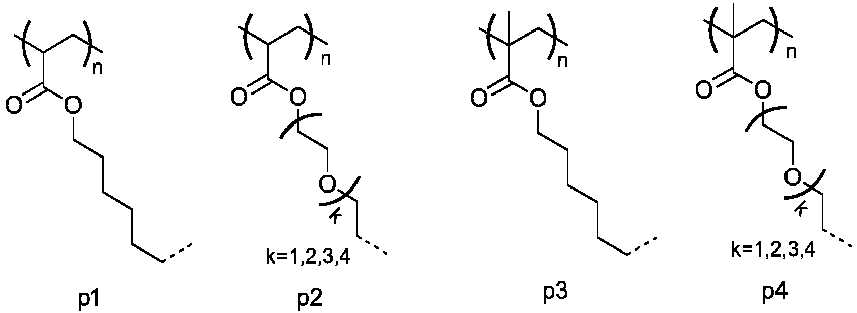

11. A substituted carba-*closo-*dodecaborate derivative of general formula **(1-1)**, as defined in one of claims 6 to 8, as defined in claim 9, preferably having an organic group **R⁴** selected from m1 to m5 or **R⁵**, or as defined in claim 10, or having a cyclic or polycyclic organic group containing at least one ring structure having one or more -NH- groups in the ring, wherein the H of the one or more - NH- groups is replaced by a -CH₂-CH₂-O- carba-*closo*-dodecaborate group or N-C(=O)-CH₂-O- carba-*closo*-dodecaborate group.

12. The use of substituted carba-closo-dodecaborate derivatives of general formula **(1-1)** as claimed in claim 11 for preparing metal-organic coordination compounds comprising a divalent Europium coordinated by the substituted carba-closo-dodecaborate derivatives of general formula **(1-1).**

13. A charge-neutral metal-organic coordination compound comprising a divalent Europium coordinated by a macrocyclic organic ligand, wherein the macrocyclic organic ligand contains 12 to 48, preferably 15 to 24, more preferably 18 to 20 ring-forming atoms of which 2 to 4 atoms are nitrogen atoms, of which 2 to 4 atoms are oxygen and/or sulphur atoms, with the proviso that in total 4 to 6 heteroatoms are present in the ring-forming atoms, and the heteroatoms are non-adjacent, and the macrocyclic organic ligand is twofold negatively charged by two substituted carba-closo-dodecaborate derivatives of general formula **(1-1)** covalently linked therewith via two groups N-C(=O)-(CH₂)ₘ-- or via a group (**R⁷**)2N-(CH₂)ₘ-- with m being a number from 1 to 4, and the two nitrogen atoms thereof being covalently linked with each other via two hydrocarbon chains which can be interrupted by one or more non-adjacent heteroatoms, independently selected from **NR⁸**, O, S, BR⁸ with **R⁸** being hydrogen or a monovalent organic group derived from an organic molecule containing at least one hydrogen atom by removing a hydrogen atom, preferably alkyl, aryl, heteroaryl, or acyl, so that the macrocyclic ring of the macrocyclic organic ligand is formed.

14. A process for preparing the charge-neutral metal-organic coordination compound according to claim 13 by reacting the macrocyclic organic ligand with an Europium(II) compound.

15. Am organic electroluminescent device comprising:
a first electrode,
a second electrode,
and an organic layer disposed between the first electrode and the second electrode, the organic layer comprising at least one charge-neutral metal-organic coordination compound according to claim 13.

## Amended claims

### Amended claims in accordance with Rule 137(2) EPC.

1. A process for the preparation of substituted carba-*closo*-dodecaborate derivative of general formula **(1-1),** comprising two major steps:
a) reacting a starting compound of general formula **(1-2),** containing at least one OH or OD group, with an inorganic or organic base, in a solvent, to form an intermediate compound of general formula **(1-3),** in which the OH and OD groups present in **(1-2)** are converted to OX groups,
b) followed by reacting a mono-valent, divalent or multi-valent derivatization reagent with general formulae **Y-R⁶, Y-R⁴-Y,** or **YₙR⁵,** respectively, in a solvent with the compound of general formula **(1-3)** to obtain the substituted 1-carba-closo-dodecaborate derivative with the general formula **(1-1),** 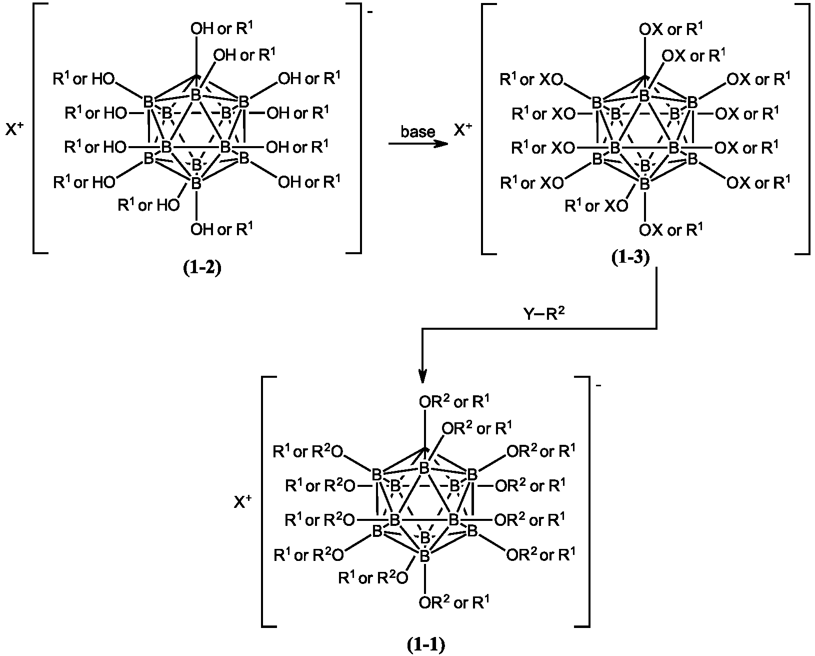
in which the OX groups present in **(1-3)** are converted to OR² groups,
with at least or exactly one OH or OD group present in the starting compound of general formula **(1-2)** which undergoes alkylation, acylation or arylation reactions, and with the non-reacted OH groups and all groups R¹ remaining unreacted during the process steps a) and b), with
• **R¹** being identical or different in each occurrence selected from hydrogen, deuterium, iodine, bromine, chlorine, fluorine, an alkyl, an alkoxy or an aryl group, preferably hydrogen or a methyl group, most preferably hydrogen;
• **X+ or X** being a monocation identical or different in each occurrence selected from lithium, sodium, potassium, caesium, rubidium, silver, ammonium or alkyl ammonium, or half equivalents of a dication selected from: beryllium, magnesium, calcium, strontium or barium, preferably lithium, sodium or potassium, more preferably sodium;
• **Y** being a monovalent leaving group selected from iodide, bromide, chloride, fluoride, tosylate, mesylate, triflate or other chemical leaving groups Y that are cleaved from the molecule under reaction conditions, allowing the R groups to react with the -OX group of compound (1-3);
• **R²** being a monovalent organic group **R⁶**, a divalent organic group **R⁴** being covalently linked to a second carba-closo-dodecaborate derivative of general formula **(1-1)** or a polyvalent organic group **R⁵** being covalently linked to (n-1) further carba-*closo*-dodecaborate derivatives of general formula **(1-1);**
• **R⁴** being a divalent organic group being identical or different in each occurrence and derived from an organic molecule containing at least two hydrogen atoms by removing two hydrogen atoms, selected from an aliphatic or aromatic hydrocarbon than can contain cyclic or heterocyclic groups and substituents;
• **R⁶** being a monovalent organic group being identical or different in each occurrence and derived from an organic molecule containing at least one hydrogen atom by removing a hydrogen atom, selected from alkyl, aryl, heteroaryl, or acyl;
• **R⁵** being a polyvalent organic group being identical or different in each occurrence and derived from an organic molecule containing at least n hydrogen atoms by removing n hydrogen atoms, selected from an organic polymer containing side groups from which the hydrogen atoms are removed;
**n** being a number of at least 3, preferably at least 10, more preferably at least 50; wherein in formula **(1-2), R¹** can replace **OH,** in formula **(1-3), OX,** in formula **(1-1), OR²** in the respective positions of the carba-*closo*-dodecaborate structure;
wherein the starting compound of general formula **(1-2)** has only a single OH group, in the vertex 12 position, and all other 11 groups of R¹ are hydrogen, and X⁺ present in the starting compound of general formula (1-2) is alkali or tri-alkylammonium, and X and X⁺ present in the intermediate compound of general formula (1-3) are alkali or tri-alkylammonium.

2. The process according to claim 1, wherein X+ present in the starting compound of general formula (1-2) is tri-alkylammonium, and X and X+ present in the intermediate compound of general formula (1-3) are bis-sodium, and wherein formula **(1-2)** and **(1-3)** are as follows:

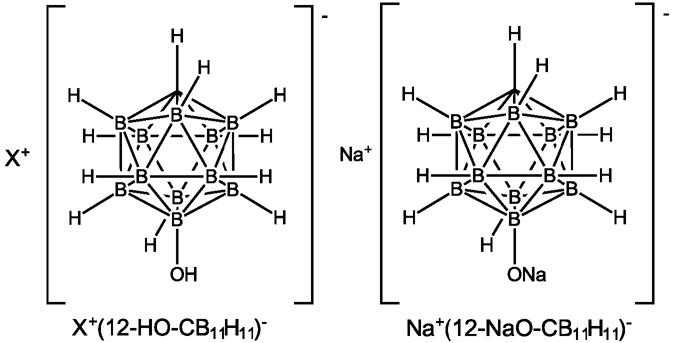

3. The process according to claim 1 or 2, wherein the solvent is an aprotic solvent, preferably selected from toluene, diethyl ether, dioxane, dimethylsulphoxide, acetonitrile, dimethylformamide (DMF), or their mixtures, more preferably from DMF and THF, most preferably from THF.

4. The process according to any one of claims 1 to 3, wherein the derivatization agent **Y-R²** is selected from Cl-CH₂-CO-NH-**R³**, Br-CH₂-CO-NH-**R³**, I-CH₂-CO-NH-**R³**, Cl-CH₂-COO-**R³**, Br-CH₂-CO-O-**R³**, I-CH₂-CO-O-R³, Cl-CH₂-CO-R³, Br-CH₂-CO-**R³**, I-CH₂-CO-**R³**, Cl-CO-**R³**, Br-CO-**R³**, with **R³** representing any covalently linked monovalent organic group formed by removing a hydrogen atom from an organic molecule containing at least one hydrogen atom.

5. The process according to any one of claims 1 to 4 wherein the base is selected from alkali hydroxides, alkali alkoxides, alkali bis(trimethylsilyl)amides, alkali diisopropylamides, organolithium reagents, trialkylamines, or organic superbases, selected from aminophosphines, phosphazenes, phosphanes, carbodiphosphoranes, amidines, guanidines, multicyclic polyamines, bispidines, or their mixtures.

6. The process according to any one of claims 1 to 5, wherein the groups **R⁴**, **R⁵** and **R⁶** are covalently linked to Y or the substituted carba-*closo*-dodecaborate derivative of general formula **(1-1)** via a group (**R⁷**)₂N-C(=O)-(CH₂)ₘ--- or via a group (**R⁷**)2N-(CH₂)ₘ-- wherein m being a number from 1 to 4, (**R⁷**)₂ is the remainder of the groups **R⁴**, **R⁵** and **R⁶** and-- is the linkage to the oxygen of the carba-*closo*-dodecaborate derivative, and wherein the two groups the groups **R⁷** can be the same or different and can be covalently linked with each other.

7. The process according to claim 6, wherein R⁴ is covalently linked to Y or the substituted carba-*closo*-dodecaborate derivative of general formula **(1-1):** via two groups N-C(=O)-(CH₂)ₘ--- or via a group (**R⁷**)2N-(CH₂)ₘ-with m being a number from 1 to 4, and the two nitrogen atoms thereof are covalently linked with each other via two hydrocarbon chains which can be interrupted by one or more non-adjacent heteroatoms, independently selected from NR⁸, O, S, BR⁸ with R⁸ being hydrogen or a monovalent organic group derived from an organic molecule containing at least one hydrogen atom by removing a hydrogen atom, preferably alkyl, aryl, heteroaryl, or acyl, so that a heterocyclic group is formed.

8. The process according to claim 7, wherein the heterocyclic group contains 12 to 48, preferably 15 to 24, more preferably 18 to 20 ring-forming atoms of which 2 to 4 atoms are nitrogen atoms, of which 2 to 4 atoms are oxygen and/or sulphur atoms, with the proviso that in total 4 to 6 heteroatoms are present in the ring-forming atoms, and the heteroatoms are non-adjacent.

9. The process according to any one of claims 1 to 8, wherein organic group R⁶ is selected from s1 to s8, s10 to s19, s21 to s42, with the dashed line indicating the linkage to Y or the oxygen of the substituted carba-*closo*-dodecaborate derivative of general formula **(1-1)** 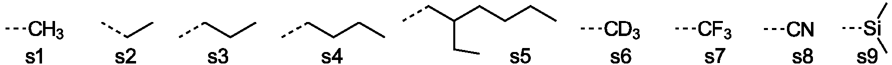 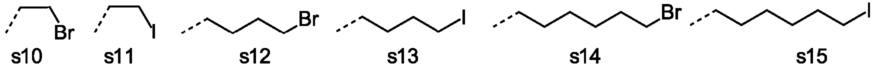 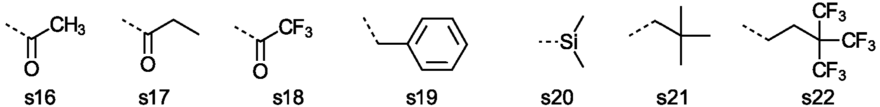 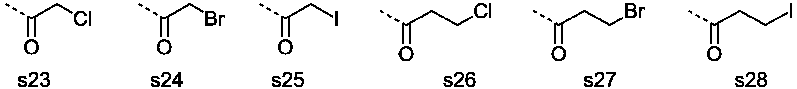 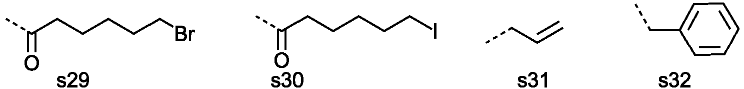 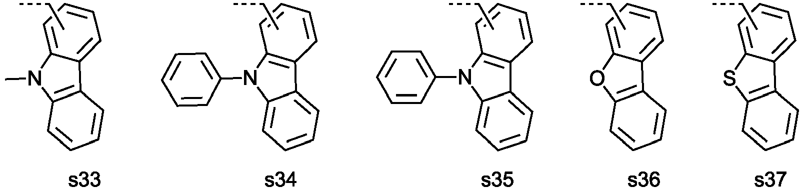 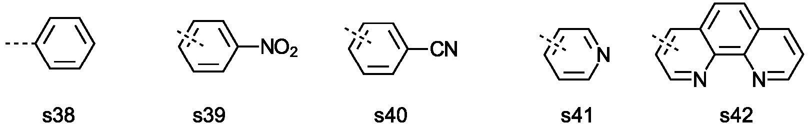
and organic group R⁴ is selected from m1 to m5, with the dashed line indicating the linkage to Y or the oxygen of the substituted carba-closo-dodecaborate derivative of general formula (1-1) 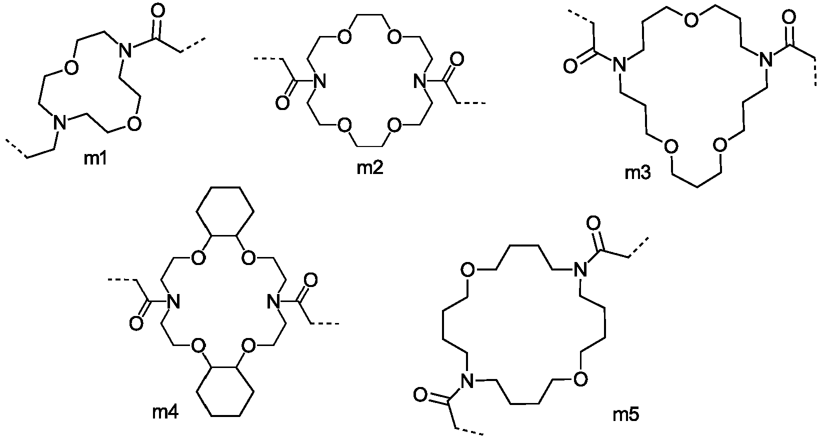
and **YₙR⁵** is a multivalent organic compound having a molecular weight of more than 1500 g/mol, and wherein the number **n** of leaving groups **Y** is greater than two, preferably greater than ten, most preferably, greater than fifty, such that a multitude of substituted carba-*closo*-dodecaborates according to formula (1-1) is covalently attached to a linear or branched polymer backbone.

10. The process according to claim 9, wherein the multivalent organic group **R⁵** is selected from p1 to p4, with n being greater than two, preferably greater than ten, most preferably greater than fifty, with k being a number from 1 to 4, and the dashed line indicating the linkage to the oxygen of the substituted carba-closo-dodecaborate derivative of general formula (1-1)

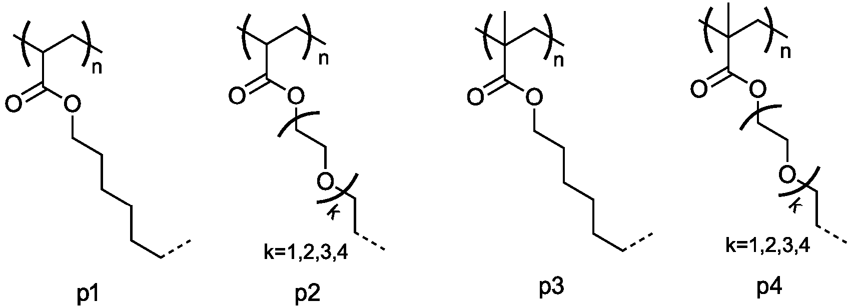

11. A substituted carba-*closo*-dodecaborate derivative of general formula **(1-1)** , as defined in one of claims 6 to 8, as defined in claim 9, preferably having an organic group **R⁴** selected from m1 to m5 or **R⁵ ,** or as defined in claim 10, or having a cyclic or polycyclic organic group containing at least one ring structure having one or more -NH- groups in the ring, wherein the H of the one or more -NH- groups is replaced by a -CH₂-CH₂-O- carba-*closo*-dodecaborate group or N-C(=O)-CH₂-O- carba-*closo*-dodecaborate group.

12. The use of substituted carba-*closo*-dodecaborate derivatives of general formula **(1-1)** as claimed in claim 11 for preparing metal-organic coordination compounds comprising a divalent Europium coordinated by the substituted carba-*closo*-dodecaborate derivatives of general formula **(1-1).**
